# EUROPEAN PATENT APPLICATION

(11) **EP 4 734 368 A1**
(43) Date of publication of application: **29.04.2026**
(21) Application number: 25207348.1
(22) Date of filing: 07.10.2025
(51) Int. Cl.: H03K 5/156, H03K 7/08, H02M 7/5395, H02M 1/08

(54) **SYSTEMS AND METHODS FOR DUTY CYCLE ADJUSTOR AND PULSE DEMODULATOR FOR INVERTER FOR ELECTRIC VEHICLE**

(30) Priority: 24.10.2024 US 202418925964
(71) Applicant: Borgwarner Inc., Auburn Hills, Michigan 48326 (US)
(72) Inventor: VIJAYKUMAR, Srikanth, Warmel, IN (US)
(74) Representative: Office Freylinger

(57) **Abstract**

A system includes an inverter configured to convert DC power from a battery to AC power, wherein the inverter includes: a pulse demodulator including: an analog timer including: a first stage pulse generator, a second stage pulse generator connected to the first stage pulse generator, and a third stage pulse generator connected to the second stage pulse generator; and a voltage translator including: a voltage divider connected to the first stage pulse generator, the second stage pulse generator, and the third stage pulse generator, and a comparator connected to the voltage divider.

## Description

### TECHNICAL FIELD

Various embodiments of the present disclosure relate generally to systems and methods for a duty cycle adjustor and a pulse demodulator, and, more particularly, to systems and methods for a duty cycle adjustor and a pulse demodulator for a galvanic isolation receiver for an inverter for an electric vehicle.

### BACKGROUND

Inverters, such as those used to drive a motor in an electric vehicle, for example, are responsible for converting High Voltage Direct Current (HVDC) into Alternating Current (AC) to drive the motor. In an inverter, communication issues across a galvanic interface may affect an operation of a gate driver and/or power device switches, and therefore may affect an operation of the inverter.

The present disclosure is directed to overcoming one or more of these above-referenced challenges.

### SUMMARY OF THE DISCLOSURE

In some aspects, the techniques described herein relate to a system including an inverter configured to convert DC power from a battery to AC power, wherein the inverter includes: a pulse demodulator including: an analog timer including: a first stage pulse generator, a second stage pulse generator connected to the first stage pulse generator, and a third stage pulse generator connected to the second stage pulse generator; and a voltage translator including: a voltage divider connected to the first stage pulse generator, the second stage pulse generator, and the third stage pulse generator, and a comparator connected to the voltage divider.

In some aspects, the techniques described herein relate to a system, wherein the first stage pulse generator includes: a first rising edge detector; a first ramp generator with a first trimmed current; a first comparator; and a first switch; wherein the first switch connects an output of the first rising edge detector to the first ramp generator, and wherein the first switch is operated based on an output of the first comparator.

In some aspects, the techniques described herein relate to a system, wherein the second stage pulse generator includes: a second rising edge detector; a second ramp generator with a second trimmed current; a second comparator; and a second switch, wherein the second switch connects the output of the second rising edge detector to the second ramp generator, and wherein the second switch is operated based on the output of the second comparator and the output of the first comparator.

In some aspects, the techniques described herein relate to a system, wherein the second stage pulse generator further includes a logic gate including: a first input connected to the output of the first comparator, a second input connected to the output of the second comparator, and an output configured to control an operation of the second switch.

In some aspects, the techniques described herein relate to a system, wherein the logic gate is configured to control the second switch to open, to disconnect an output of the second rising edge detector from an input of the second ramp generator, when the output of the first comparator is OFF and the output of the second comparator is ON.

In some aspects, the techniques described herein relate to a system, wherein the third stage pulse generator includes: a third rising edge detector; a third ramp generator with a third trimmed current; a third comparator; and a third switch, wherein the third switch connects the output of the third rising edge detector to the third ramp generator, and wherein the third switch is operated based on the output of the third comparator and the output of the second comparator.

In some aspects, the techniques described herein relate to a system, wherein: the analog timer further includes a fourth stage pulse generator connected to the third stage pulse generator; and the voltage divider is further connected to the fourth stage pulse generator.

In some aspects, the techniques described herein relate to a system, wherein the fourth stage pulse generator includes: a fourth rising edge detector; a fourth ramp generator with a fourth trimmed current; a fourth comparator; and a fourth switch, wherein the fourth switch connects the output of the fourth rising edge detector to the fourth ramp generator, and wherein the fourth switch is operated based on the output of the fourth comparator and the output of the third comparator.

In some aspects, the techniques described herein relate to a system, wherein the voltage divider includes: a first resistor string connected to the first stage pulse generator, a first resistor tap point from the first resistor string, a second resistor string connected to the second stage pulse generator, a second resistor tap point from the second resistor string, a third resistor string connected to the third stage pulse generator, a third resistor tap point from the third resistor string, a fourth resistor string connected to the fourth stage pulse generator, and a fourth resistor tap point from the fourth resistor string.

In some aspects, the techniques described herein relate to a system, wherein the inverter further includes: a duty cycle adjustor connected to the pulse demodulator.

In some aspects, the techniques described herein relate to a system, wherein the voltage divider includes: a first resistor string connected to the first stage pulse generator, a first resistor tap point from the first resistor string, a second resistor string connected to the second stage pulse generator, a second resistor tap point from the second resistor string, a third resistor string connected to the third stage pulse generator, and a third resistor tap point from the third resistor string.

In some aspects, the techniques described herein relate to a system, wherein the comparator of the voltage translator is configured to output a signal based on a threshold voltage and one or more output signals of the analog timer.

In some aspects, the techniques described herein relate to a system, further including: the battery configured to supply the DC power to the inverter; and a motor configured to receive the AC power from the inverter to drive the motor, wherein the inverter, the battery, and the motor are provided as a vehicle.

In some aspects, the techniques described herein relate to a system including a pulse demodulator, wherein the pulse demodulator includes: an analog timer including: a first stage pulse generator, a second stage pulse generator connected to the first stage pulse generator, and a third stage pulse generator connected to the second stage pulse generator; and a voltage translator including: a voltage divider connected to the first stage pulse generator, the second stage pulse generator, and the third stage pulse generator, and a comparator connected to the voltage divider.

In some aspects, the techniques described herein relate to a system, wherein the voltage translator is configured to output a signal based on a summation of an output of the first stage pulse generator, an output of the second stage pulse generator, and an output of the third stage pulse generator.

In some aspects, the techniques described herein relate to a method including: receiving an input pulse; generating a first rising edge pulse based on the input pulse; generating a first ramp signal based on the first rising edge pulse; generating a first comparator signal based on the first ramp signal; generating a second rising edge pulse based on the input pulse and the first ramp signal; generating a second ramp signal based on the second rising edge pulse; generating a second comparator signal based on the second ramp signal; and generating a summation signal of the first comparator signal and the second comparator signal.

In some aspects, the techniques described herein relate to a method, wherein the generating the first rising edge pulse includes: comparing a first pulse of the input pulse with a threshold voltage of a first comparator; and closing a switch allowing a rising ramp generator to receive the first rising edge pulse based on an output of the first comparator when the voltage surpasses the threshold voltage set by the first comparator.

In some aspects, the techniques described herein relate to a method, wherein generating the first ramp signal includes: receiving the first rising edge pulse and generating a rising ramp signal based on the first rising edge pulse.

In some aspects, the techniques described herein relate to a method, wherein generating the first comparator signal includes: comparing the first ramp signal with a threshold voltage, wherein an output of the first comparator remains high until the ramp voltage surpasses the threshold voltage, and wherein when the ramp voltage surpasses the threshold voltage the output goes low and a switch opens.

In some aspects, the techniques described herein relate to a method, wherein generating the second rising edge pulse includes: comparing a received pulse and the first ramp signal; and detecting the received pulse and turning off a switch thereby disconnecting the input from the ramp generator, wherein an output of the second comparator remains high until a voltage of the second ramp signal surpasses a threshold voltage set in the comparator.

In some aspects, the techniques described herein relate to a system including an inverter configured to convert DC power from a battery to AC power, wherein the inverter includes: a duty cycle adjustor including: a rising edge detector to detect a rising edge of a periodic signal; a ramp generator connected to the rising edge detector; a first comparator connected to the ramp generator; a duty cycle trimmer connected to the first comparator; and a bidirectional current trimmer connected to the duty cycle trimmer and the ramp generator.

In some aspects, the techniques described herein relate to a system, wherein the ramp generator includes: a capacitor, a switch to turn on based on the rising edge to connect the capacitor to ground, and a current source.

In some aspects, the techniques described herein relate to a system, wherein the periodic signal is a fixed frequency signal.

In some aspects, the techniques described herein relate to a system, wherein the duty cycle adjustor is provided in a high voltage area of the inverter that is separated from a low voltage area of the inverter by a galvanic isolator.

In some aspects, the techniques described herein relate to a system, wherein the duty cycle trimmer includes one or more processors.

In some aspects, the techniques described herein relate to a system, wherein the one or more processors include a window comparator.

In some aspects, the techniques described herein relate to a system, wherein the one or more processors include an analog to digital converter.

In some aspects, the techniques described herein relate to a system, wherein the inverter further includes: a demodulator connected to the duty cycle adjustor.

In some aspects, the techniques described herein relate to a system, wherein the inverter further includes: an amplifier; and a second comparator connected to the amplifier and the duty cycle adjustor.

In some aspects, the techniques described herein relate to a system, further including: the battery configured to supply the DC power to the inverter; and a motor configured to receive the AC power from the inverter to drive the motor, wherein the inverter, the battery, and the motor are provided as a vehicle.

In some aspects, the techniques described herein relate to a system including a duty cycle adjustor including: a rising edge detector to detect a rising edge of a periodic signal; a ramp generator connected to the rising edge detector; a comparator connected to the ramp generator; a duty cycle trimmer connected to the comparator; and a bidirectional current trimmer connected to the duty cycle trimmer and the ramp generator.

In some aspects, the techniques described herein relate to a system, wherein the rising edge detector is configured to generate a rising edge signal based on the rising edge of the periodic signal.

In some aspects, the techniques described herein relate to a system, wherein the ramp generator includes a switch to connect a capacitor to ground based on the rising edge signal to generate a ramp signal.

In some aspects, the techniques described herein relate to a system, wherein the comparator is configured to generate a pulse based on the ramp signal and a threshold.

In some aspects, the techniques described herein relate to a system, wherein the duty cycle trimmer is configured to generate a multi-bit output based on the pulse.

In some aspects, the techniques described herein relate to a system, wherein the bidirectional current trimmer is configured to generate a reference current to the ramp generator to adjust the ramp signal.

In some aspects, the techniques described herein relate to a method including: adjusting a counter based on a measured value, a target value, an upper tolerance, a lower tolerance, and a direction; calibrating a duty cycle based on the counter; and demodulating a signal based on the duty cycle.

In some aspects, the techniques described herein relate to a method, wherein the adjusting the counter includes: incrementing the counter when a difference between the measured value and the target value is greater than the upper tolerance and the direction is zero; incrementing the counter when the difference between the measured value and the target value is greater than the lower tolerance and the direction is one; decrementing the counter when the difference between the measured value and the target value is greater than the lower tolerance and the direction is zero; and decrementing the counter when the difference between the measured value and the target value is greater than the upper tolerance and the direction is one.

In some aspects, the techniques described herein relate to a method, wherein the calibrating the duty cycle based on the counter includes: detecting a rising edge of a periodic signal; generating a ramp signal based on the rising edge; comparing the ramp signal to a threshold; and calibrating the duty cycle based on the counter and the comparing.

In some aspects, the techniques described herein relate to a method, wherein the demodulating the signal includes: receiving a modulated signal; detecting an envelope of the modulated signal based on the duty cycle; and generating a demodulated signal based on the envelope.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a combined inverter and converter, according to one or more embodiments.
FIG. 2 depicts an exemplary system infrastructure for the combined inverter and converter of FIG. 1 with a point-of-use switch controller, according to one or more embodiments.
FIG. 3 depicts an exemplary system infrastructure for the controller of FIG. 2, according to one or more embodiments.
FIG. 4 depicts an exemplary system infrastructure for a galvanic isolation of a low voltage and high voltage controller of FIG. 2, according to one or more embodiments.
FIG. 5 depicts an exemplary system infrastructure for a duty cycle adjustor and a pulse demodulator for the galvanic isolation receiver, according to one or more embodiments.
FIG. 6 depicts an exemplary system infrastructure for a duty cycle adjustor, according to one or more embodiments.
FIG. 7 depicts an exemplary system infrastructure for a bidirectional current trimmer, according to one or more embodiments.
FIG. 8 depicts an exemplary algorithm for duty cycle calibration, according to one or more embodiments.
FIG. 9 depicts an exemplary system infrastructure for a duty cycle calibration using a window comparator, according to one or more embodiments.
FIG. 10 depicts an exemplary system infrastructure for a duty cycle calibration using an analog to digital converter, according to one or more embodiments.
FIG. 11 depicts an exemplary algorithm for a duty cycle calibration counter, according to one or more embodiments.
FIG. 12 depicts a zoomed-out exemplary plot for waveforms of input clock, calibrated clock, calibration error, and trim code, according to one or more embodiments.
FIG. 13 depicts a zoomed-in exemplary plot for waveforms of input clock, calibrated clock, calibration error, and trim code, according to one or more embodiments.
FIG. 14 depicts an exemplary plot for a duty cycle calibration using a window comparator, according to one or more embodiments.
FIG. 15 depicts an exemplary plot for a duty cycle calibration using a window comparator, according to one or more embodiments.
FIG. 16 depicts an exemplary plot for a duty cycle calibration using a window comparator, according to one or more embodiments.
FIG. 17A depicts an exemplary system infrastructure for an analog timer for the pulse demodulator of FIG. 5, according to one or more embodiments.
FIG. 17B depicts an exemplary stage of the analog timer of FIG. 17A, according to one or more embodiments.
FIG. 18 depicts an exemplary system infrastructure for a voltage translator for the pulse demodulator of FIG. 5, according to one or more embodiments.
FIG. 19 depicts an exemplary plot for demodulator waveforms in an ideal ramp rate, according to one or more embodiments.
FIG. 20 depicts an exemplary plot for demodulator waveforms with a faster ramp rate, according to one or more embodiments.
FIG. 21 depicts an exemplary plot for demodulator waveforms with a slower ramp rate, according to one or more embodiments.
FIG. 22 depicts an exemplary plot for demodulator waveforms from various stages, according to one or more embodiments.
FIG. 23 depicts an exemplary plot for rising edges of averaged comparator outputs, according to one or more embodiments.
FIG. 24 depicts an exemplary plot for falling edges of averaged comparator outputs, according to one or more embodiments.
FIG. 25 depicts an exemplary plot for demodulated signals, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to systems and methods for a duty cycle adjustor and a pulse demodulator, and, more particularly, to systems and methods for a duty cycle adjustor and a pulse demodulator for a galvanic isolation receiver for an inverter for an electric vehicle.

Inverters, such as those used to drive a motor in an electric vehicle, for example, are responsible for converting High Voltage Direct Current (HVDC) into Alternating Current (AC) to drive the motor. A three phase inverter may include a bridge with six power device switches (for example, power transistors such as IGBT or MOSFET) that are controlled by Pulse Width Modulation (PWM) signals generated by a controller. An inverter may include three phase switches to control the phase voltage, upper and lower gate drivers to control the switches, a PWM controller, and glue logic between the PWM controller and the gate drivers. The PWM controller may generate signals to define the intended states of the system. The gate drivers may send the signals from the PWM controller to the phase switches. The phase switches may drive the phase voltage. The inverter may include an isolation barrier between low voltage and high voltage planes. Signals may pass from the PWM controller to the phase switches by passing across the isolation barrier, which may employ optical, transformer-based, or capacitance-based isolation. PWM signals may be distorted when passing through the glue logic, which may include resistive, capacitive, or other types of filtering. PWM signals may be distorted when passing through the gate driver, due to the galvanic isolation barrier and other delays within the gate driver. PWM signals may be distorted when the signals processed by the phase switch via the gate driver output.

Gate drivers may tolerate common-mode transients that occur during field-effect transistor (FET) switching and when one side of the floating high voltage terminal is shorted to ground or subject to an electro-static discharge. These voltage transients may result in fast edges, which may create bursts of common-mode current through the galvanic isolation. A gate driver may need to demonstrate common-mode transient immunity (CMTI) in order to be effective and safe.

Gate drivers may have a high-voltage domain in common to the voltage plane of an associated FET. Further, high-voltage planes may be supplied by a flyback converter that may be isolated through a transformer from the low-voltage plane. The high-voltage domain supply may be used to power circuits which source and sink gate current to drive the FET and which may detect FET faults so the faults can be acted upon and/or communicated to the low-voltage domain. Gate drivers may include a galvanic channel dedicated to FET commands, and one or more bidirectional or unidirectional galvanic channels dedicated to FET communications.

High current switching transients may create strong electro-magnetic (EM) fields that may couple into nearby metal traces. The magnitude and frequency of coupled currents may depend upon the layout of the FET packaging solution and the direction and length of metal traces between the FET and the control integrated circuit (IC). For example, typical values for coupled currents may be up to 1A at AC frequencies up to 100MHz. Typically, within a circuit, the gate driver IC may be placed far enough away from the FET that high EM fields do not couple directly into the internal metal traces within the gate driver IC. The gate driver is placed a distance from EM fields such that induced currents within the circuitry are below levels that will cause malfunction of the gate driver, or a metal shield is placed between the gate driver and the source of EM fields to protect the gate driver circuitry. The output terminals of the gate driver that connect to the FET are exposed to the EM fields at the point where the output terminals are no longer covered by a shield. The gate driver switches large currents (such as 5A to 15A, for example) through these exposed terminals. The switched large currents are generally greater in magnitude than the EM-induced currents. The gate driver is able to overdrive the induced currents to maintain control of the FETs. The high side of the gate drivers and the FET may share a common ground and a gate control signal trace, both of which may be susceptible to coupled currents.

As introduced above, galvanic isolation may include isolating functional sections of electrical systems to prevent current flow such that, for example, no direct conduction path is permitted between such functional sections. For example, two circuits may be galvanically isolated such that the circuits are configured to communicate with each other, but may have respective reference grounds at different potentials. For example, some architectures use a circuit with four galvanic isolators, such as four capacitors, for transferring data between low voltage and high voltage planes. The galvanic isolation may include optical, transformer-based, or capacitance-based isolation, for example.

A gate driver may be a power amplifier or other electrical component that accepts an input from a controller, and may generate a drive input for the gate of a transistor. Galvanically isolated gate drivers may be used in automotive and industrial applications for communication between low voltage and high voltage planes, without causing harm to users or equipment.

A low voltage side transmitter of an integrated circuit may be connected to one or more capacitors at a high voltage side of a circuit, such as an integrated circuit, for example. A poor connection may result in a loss of the differential nature of a given galvanic interface. Such a loss of the differential nature may render the galvanic interface and/or the gate drive integrated circuit more susceptible to interference (e.g., electromagnetic interference). For example, such interference may include common mode radio frequency (RF) noise (CMRFI).

Interference (e.g., electromagnetic interference, CMRFI, etc.) may result in propagation of incorrect commands and/or messages to gate drivers. For example, as a result of interference, a high voltage controller may receive and/or apply incorrect commands and/or messages from a low voltage controller. Such incorrect commands and/or messages may increase the risk of a short between a high side controller or driver and a low side controller or driver.

Each of the high side controller and the low side controller may include a receiver to receive the commands and/or messages. The receiver may include a front-end amplifier to receive the commands and/or messages in the form of pulses, for example. Because the duty cycle of the pulses available at the output of the front-end amplifier used in the galvanic isolation receiver is variable, these pulses may be set to a known duty cycle to generate a ramp voltage that is process, supply, and temperature independent. This may reduce a timing error when using a rectification method for demodulation or any other method involving a constant duty cycle or a ramp voltage.

One or more embodiments may provide a duty cycle adjuster to address a variable duty cycle and ramp rate. The duty cycle adjuster may include a rising edge detector to receive a fixed frequency signal. The incoming pulse may be of any duty cycle, but sufficiently large enough for the edge detector to detect a rising edge of the signal. The duty cycle adjuster may include a ramp generator that includes a current source, a switch, and a capacitor that can vary across processes and temperatures, resulting in a variable ramp rate.

When the switch sees a rising edge, the switch may turn ON - connecting the capacitor to the ground through the switch. The switch may remain ON as long as the incoming rising edge pulse is high. The duty cycle adjuster may include a ramp generator with an output VRAMP connected to a comparator that generates pulses when VRAMP is below a threshold. This comparator output may be used to gate the signal provided to the ramp switch. This may reduce the variability of the rising edge detector to the overall pulse width.

The output of the VRAMP comparator and a complementary signal to the output may be connected to two switches that connect a multi-order low pass filter circuit between supply and ground. The filtered output, VMes, may measure close to half-supply if the duty cycle is 50%. VMes may then be provided to a duty cycle calibration logic, where VMes is compared against a fixed voltage Vtarget. This user-adjustable Vtarget may determine the duty cycle of the generated pulse. When Vtarget may be set to half-supply, the pulse generated from the comparator output may have an approximately 50% duty cycle.

The 5-bit output of duty cycle calibration logic may be sent to a bidirectional current trimmer, which may increase or decrease the reference current provided to the ramp generator, which may adjust the ramp rate. This adjusted ramp rate may adjust the duty cycle of the comparator output pulse.

The duty cycle calibration logic may include various operations. VMes may be the voltage at the output of a multi-order low pass filter connected between the supply and ground through switches, and may be controlled by the output of the VRAMP comparator. Target_Vth may be a user-selectable threshold that determines the duty cycle of the pulses coming from the VRAMP comparator. For example, for a 50% duty cycle, Target_Vth may be set to approximately 50% of a supply voltage. For example, for an 80% duty cycle, Target_Vth may be set to approximately 75% of a supply voltage.

Tolerance may be the amount of voltage that may be tolerated as an error. This may account for errors such as the offset present in buffers that drive the VMes, small ripple voltage that is present in VMes, error associated with external measurement devices if any, error in ADC, for example.

When the duty cycle of the incoming pulse may be greater than the desired/required duty cycle, VMes voltage may become larger than Target_Vth voltage. This is because the pulse duration may be longer than ***pulse,*** thus Vmes voltage may increase. VMes voltage may be greater than (Target_Vth + Tolerance) voltage, and the ramp may be adjusted to reduce the duty cycle. The duty cycle of the pulse may be adjusted by setting the direction bit of the bidirectional current trim circuit to zero and the bits may be incremented by one. This may pull current from the ramp generator's current source, which may slow down the ramp.

The duty cycle of the incoming pulse may be less than the desired/required duty cycle, and VMes voltage may become less than Target_Vth voltage. VMes voltage may be less than Target_Vth voltage because the pulse duration may be less than ***pulse,*** which may reduce VMes voltage. When VMes voltage is less than (Target_Vth - Tolerance) voltage, the ramp may be adjusted to increase the duty cycle. The duty cycle of the pulse may be increased by setting the direction bit of the bidirectional current trim circuit to one and incrementing the current trim bits by one. This may add current to the ramp generator's current source, which may increase the ramp rate.

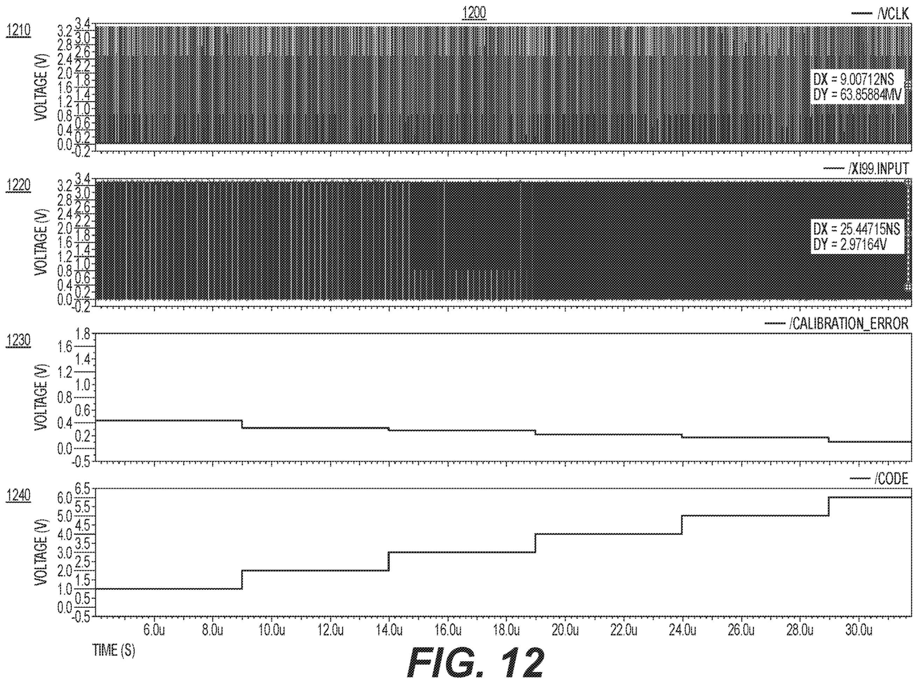

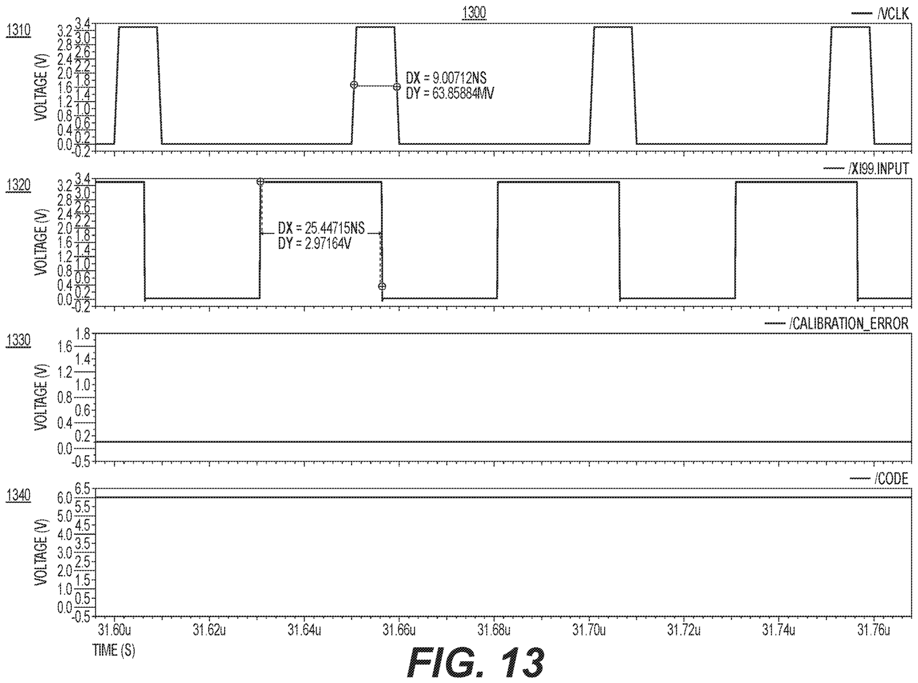

This process may continue until VMes voltage lies within (Target_Vth + Tolerance) and (Target_Vth - Tolerance). FIG. 12 and FIG. 13 may depict the input clock, duty cycle corrected clock, calibration error, and output code from the calibration logic circuit.

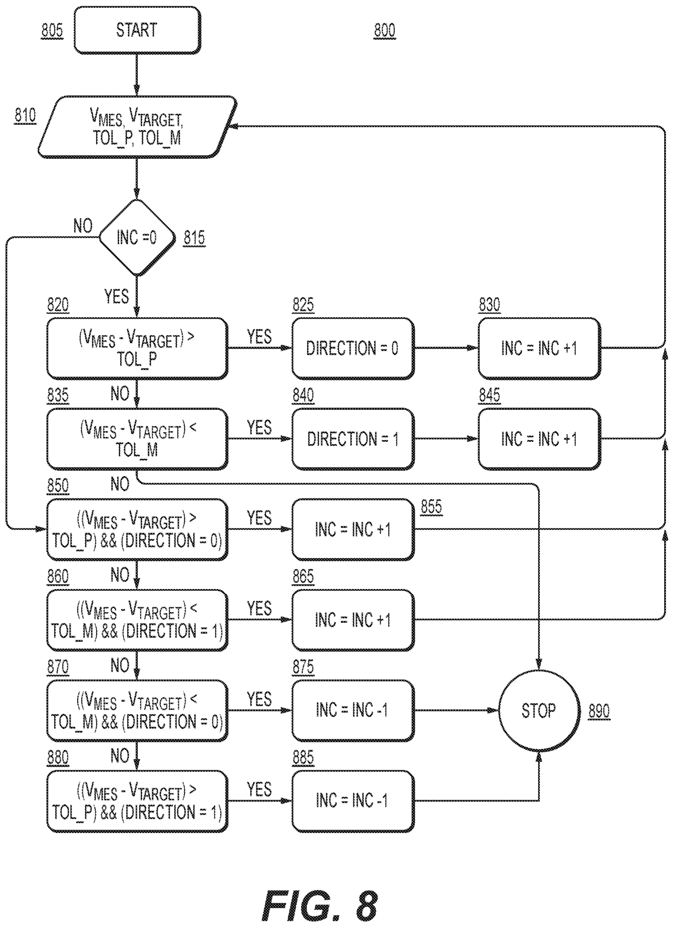

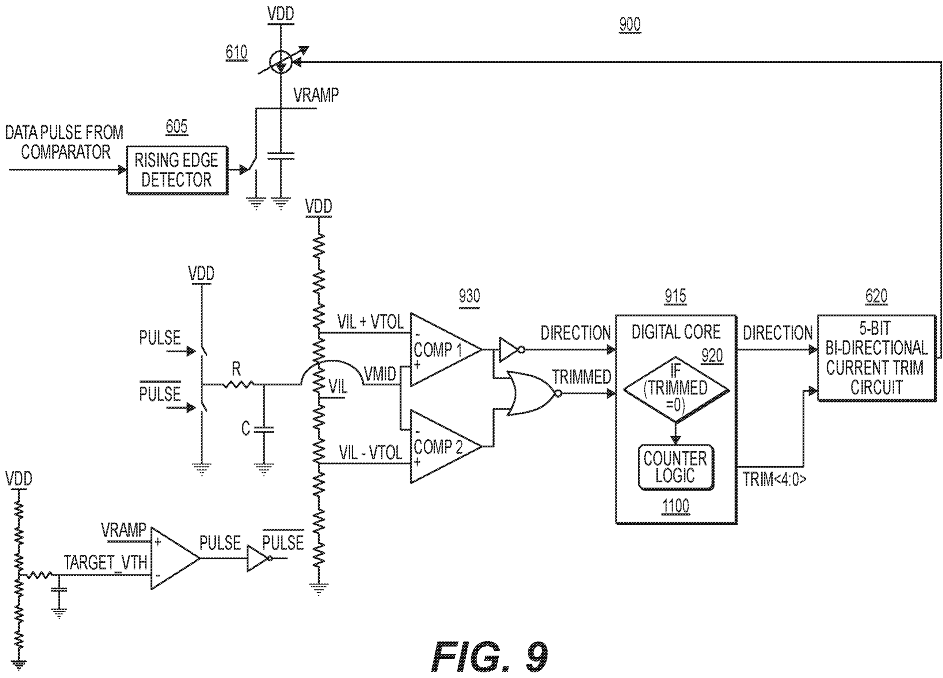

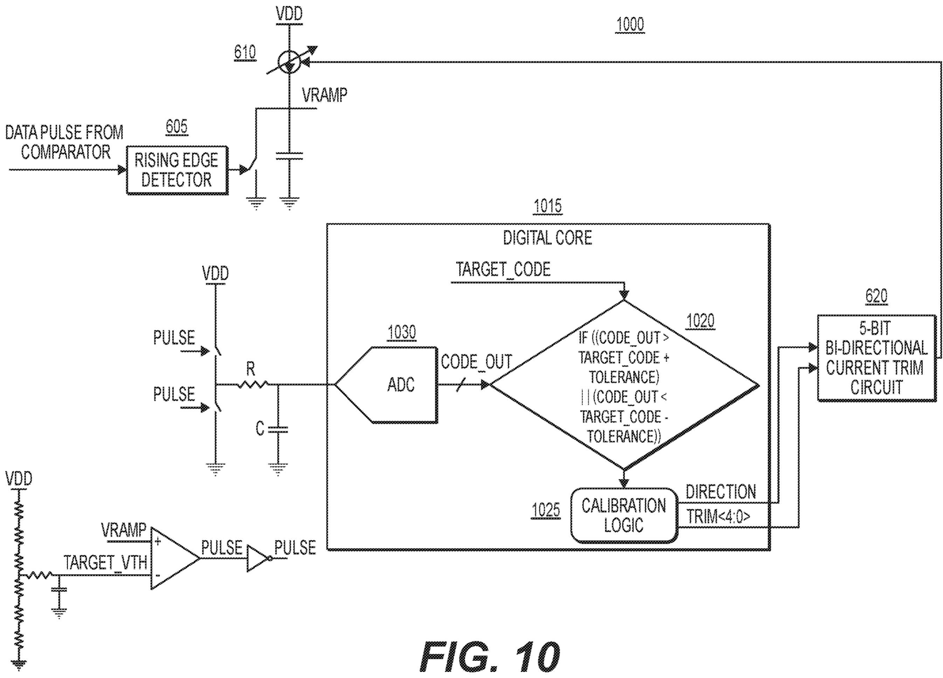

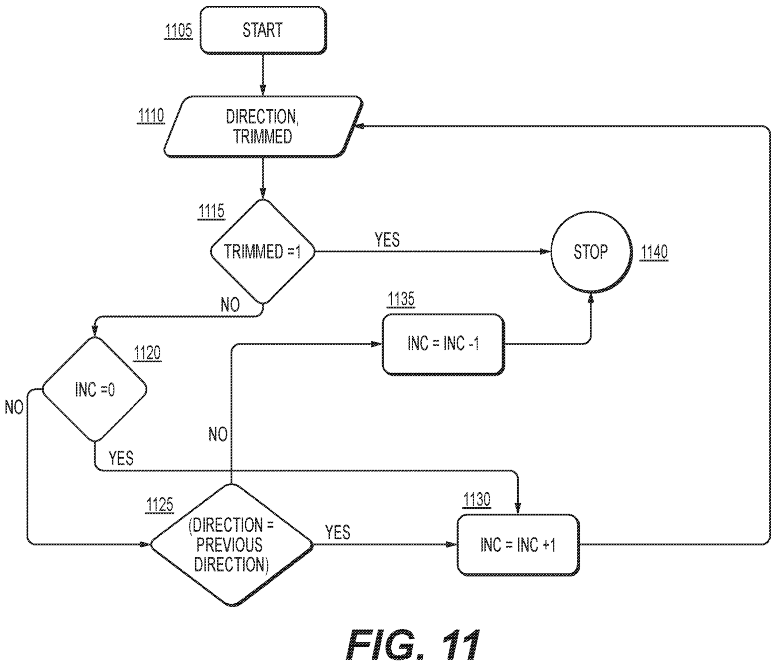

The duty cycle calibration logic may be implemented internally or externally in an integrated circuit. FIG. 9 may depict a simplified duty cycle correction circuit using a window comparator. The corresponding counter logic may be shown in FIG. 11. FIG. 10 may depict a simplified duty cycle correction circuit using an ADC and a similar logic which may be shown in FIG. 10 and FIG. 8 may be used for incrementing or decrementing the ADC code. The duty cycle calibration logic in conjunction with the bidirectional trim circuitry may reduce the effect of variations in ramp current and capacitance across process, corner, and temperature, thus, providing <2% variation in duty cycle and ramp from the target duty cycle / ramp voltage. The accuracy may be further improved by reducing the factors that increase tolerance error such as buffer offset, ripple voltage present in VMes, error associated with external measurement devices if any, error in ADC, etc.

As can be seen in FIG. 13, an incoming pulse which may have a 9ns high time and 31ns low time may be converted to a 50% ± 2% duty cycle clock.

In OOK (on-off keying) modulation, the demodulator receives data in the form of pulses, which can be corrupted by noise, leading to missing pulses. It is crucial to prevent glitching in gate drivers as this can short high and low side switches. Therefore, a robust demodulator that can handle these noises without glitching is essential.

Various methods exist for demodulating incoming pulses to an envelope. One approach involves passing the pulses through a low pass filter with a large time constant. However, this method is prone to significant errors due to process shifts in R, C, current, supply voltage, etc., resulting in distortion.

One or more embodiments may provide a demodulation method that may use a series of ramp generators gated based on the previous ramp signal output. These ramp generators may derive current for their operation based on a trimmed duty cycle correction circuit, which may ensure a constant duty cycle / ramp output even when factors such as R, C, current, and supply voltage vary over the process. The demodulation method may comprise an analog timer and a voltage translation stage.

The first stage of the analog timer may include a rising edge detector, a ramp generator with a trimmed current, a comparator, and a switch that may connect the output of the rising edge detector to the ramp generator. The switch may be controlled by the output of the comparator of the first block. Specifically, when the output of the comparator is low, the switch may connect the output of the rising edge detector to the ramp generator.

The second stage closely may resemble the first stage, except that the switch may be controlled by both the output of the comparator of the second block and the output of the previous (first) block's comparator.

The number of stages required for demodulation may depend on the maximum number of pulses that can be lost due to noise while still providing a robust non-glitch output. For example, assuming only one pulse can be lost due to noise, a minimum of three stages may be necessary. However, for enhanced system robustness, a fourth stage may be added.

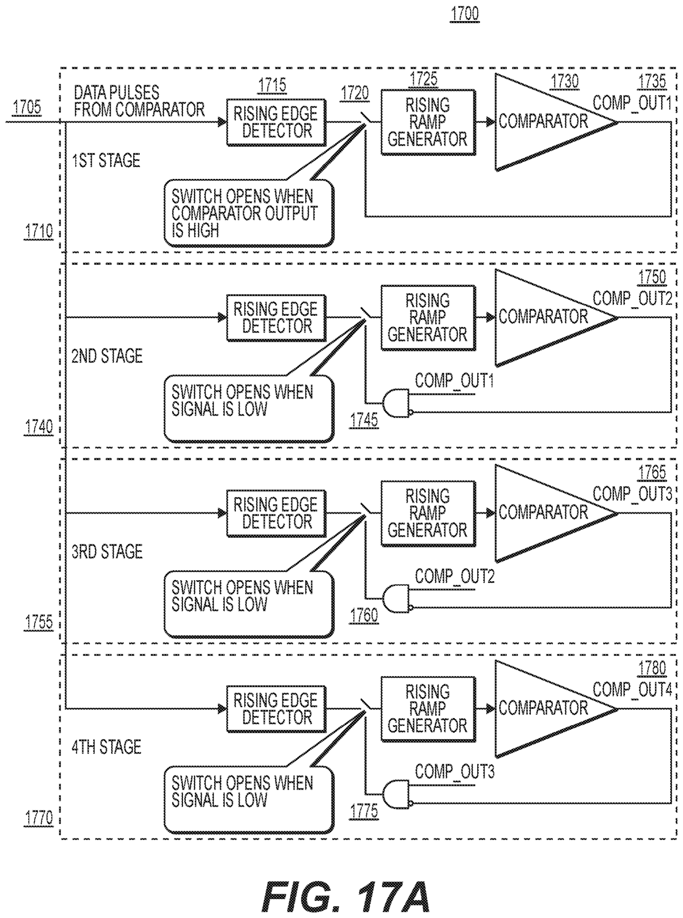

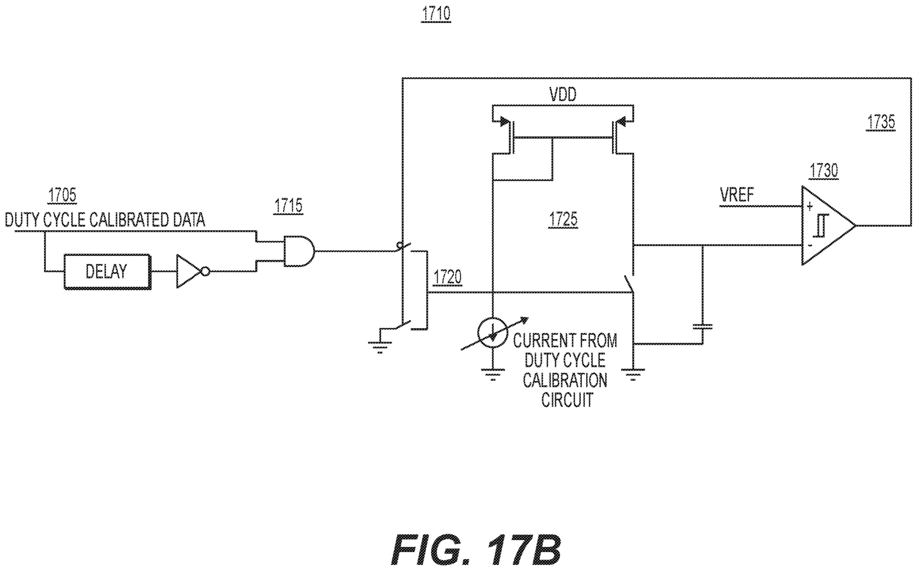

In FIG. 17A and FIG. 17B, for example, when the first-stage comparator detects the first pulse of the incoming pulse train, the switch may turn off (e.g., open), and thereby disconnecting the input from the ramp generator. The output of the comparator may stay high until the ramp voltage surpasses the threshold voltage set in the comparator. During this time, the first stage may remain disconnected from the input, so that subsequent pulses are not detected.

Once the output of the first-stage comparator is high, the second-stage switch may turn on, connecting the input to the second-stage ramp generator. When the second-stage comparator sees the second pulse, the switch may turn off, disconnecting the input from the ramp generator. The output of the second comparator may stay high until the ramp voltage surpasses the threshold voltage set in the comparator. This process may be repeated for the remaining two stages as well. Once the ramp voltage crosses the threshold voltage set in the comparator, the output of the comparator may go low, connecting the ramp generator back to the input through the switch. This process may repeat and may occur for the remaining three stages as well.

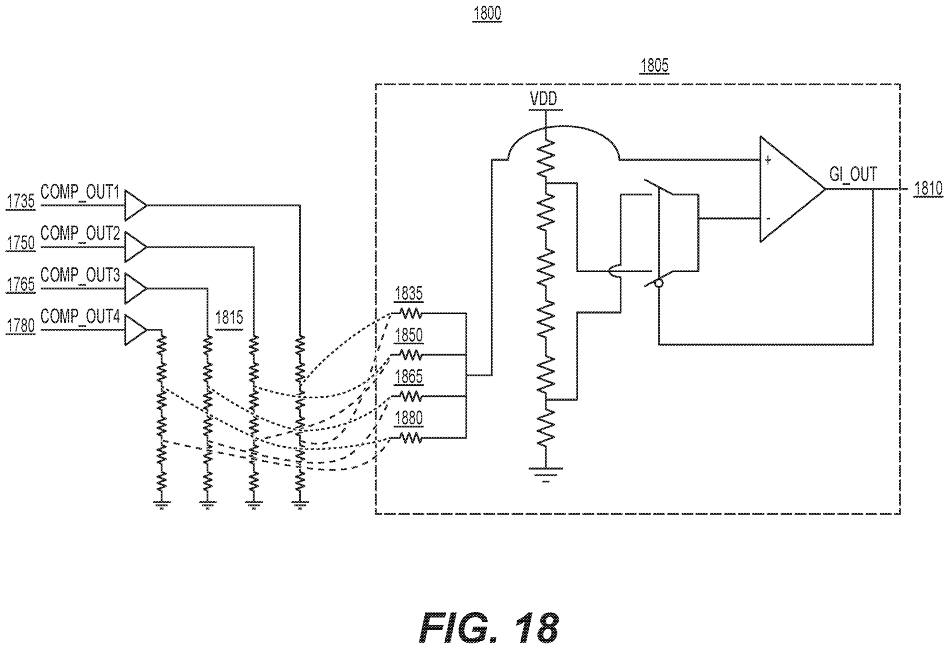

The outputs of the four comparators may be connected as shown in FIG. 18. Depending on the desired input range of the level translator detection comparator, suitable tap points from the resistor strings may be shorted. When the shorted voltage goes above the set threshold voltage, the comparator output may go high. The threshold voltage may then be set to a lower level using the switch connected to the resistor tap point and the output of the comparator. The output of the comparator may remain high until the level translator voltage goes below the lower threshold voltage.

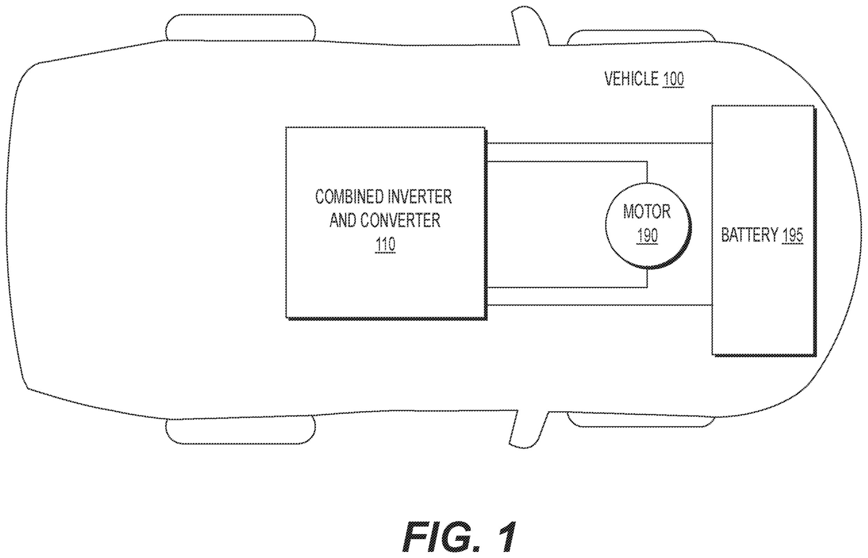

FIG. 1 depicts an exemplary system infrastructure for a vehicle including a combined inverter and converter, according to one or more embodiments. In the context of this disclosure, the combined inverter and converter may be referred to as an inverter. As shown in FIG. 1, electric vehicle 100 may include an inverter 110, a motor 190, and a battery 195. The inverter 110 may include components to receive electrical power from an external source and output electrical power to charge battery 195 of electric vehicle 100. The inverter 110 may convert DC power from battery 195 in electric vehicle 100 to AC power, to drive motor 190 of the electric vehicle 100, for example, but the embodiments are not limited thereto. The inverter 110 may be bidirectional, and may convert DC power to AC power, or convert AC power to DC power, such as during regenerative braking, for example. Inverter 110 may be a three-phase inverter, a single-phase inverter, or a multi-phase inverter.

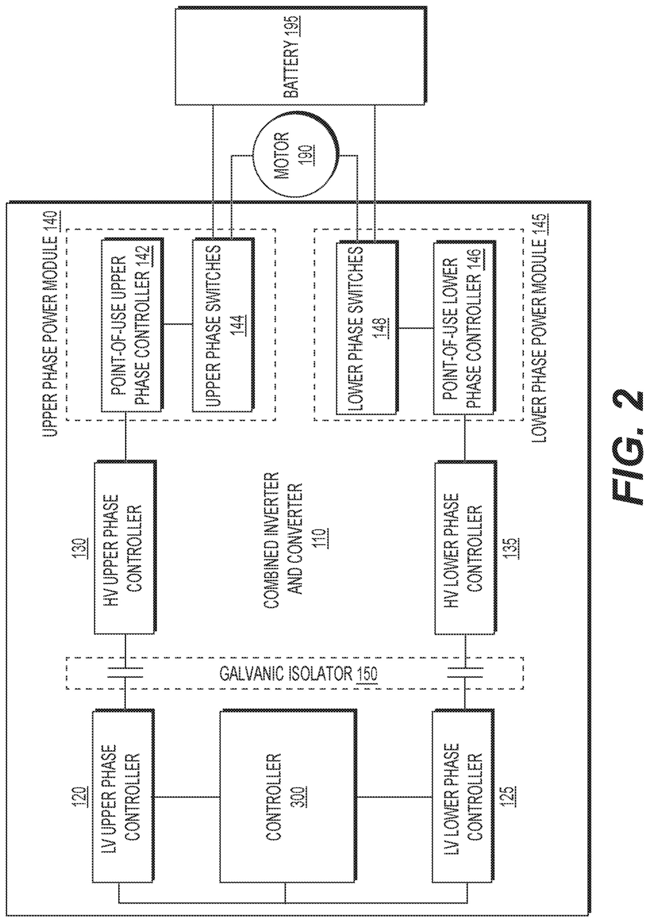

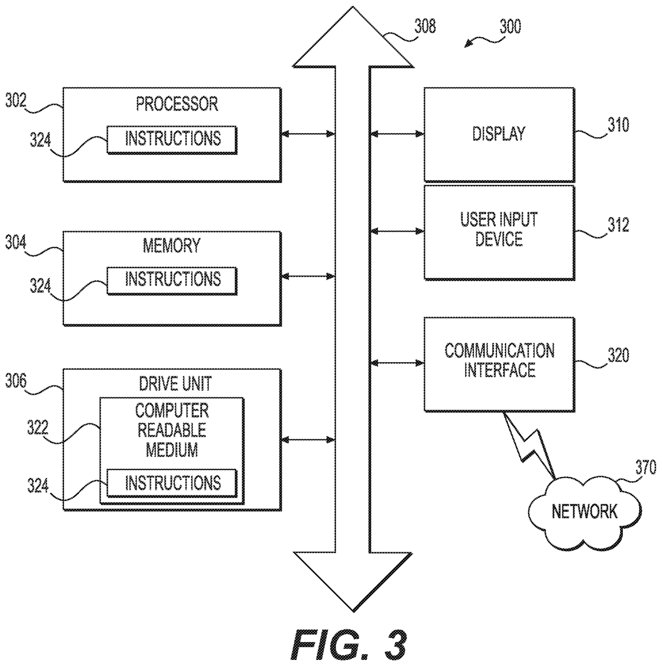

FIG. 2 depicts an exemplary system infrastructure for the inverter 110 of FIG. 1 with a point-of-use switch controller, according to one or more embodiments. Electric vehicle 100 may include inverter 110, motor 190, and battery 195. Inverter 110 may include an inverter controller 300 (shown in FIG. 3) to control the inverter 110. Inverter 110 may include a low voltage upper phase controller 120 separated from a high voltage upper phase controller 130 by a galvanic isolator 150, and an upper phase power module 140. Upper phase power module 140 may include a point-of-use upper phase controller 142 and upper phase switches 144. Inverter 110 may include a low voltage lower phase controller 125 separated from a high voltage lower phase controller 135 by galvanic isolator 150, and a lower phase power module 145. Lower phase power module 145 may include a point-of-use lower phase controller 146 and lower phase switches 148. Upper phase switches 144 and lower phase switches 148 may be connected to motor 190 and battery 195. Galvanic isolator 150 may be one or more of optical, transformer-based, or capacitance-based isolation. Galvanic isolator 150 may be one or more capacitors with a value from approximately 20fF to approximately 100fF, with a breakdown voltage from approximately 6kV to approximately 12kV, for example. Galvanic isolator 150 may include a pair of capacitors, where one capacitor of the pair carries a complementary data signal from the other capacitor of the pair to create a differential signal for common-mode noise rejection. Galvanic isolator 150 may include more than one capacitor in series. Galvanic isolator 150 may include one capacitor located on a first IC, or may include a first capacitor located on a first IC and a second capacitor located on a second IC that communicates with the first IC.

Inverter 110 may include a low voltage area, where voltages are generally less than 5V, for example, and a high voltage area, where voltages may exceed 500V, for example. The low voltage area may be separated from the high voltage area by galvanic isolator 150. Inverter controller 300 may be in the low voltage area of inverter 110, and may send signals to and receive signals from low voltage upper phase controller 120. Low voltage upper phase controller 120 may be in the low voltage area of inverter 110, and may send signals to and receive signals from high voltage upper phase controller 130. Low voltage upper phase controller 120 may send signals to and receive signals from low voltage lower phase controller 125. High voltage upper phase controller 130 may be in the high voltage area of inverter 110. Accordingly, signals between low voltage upper phase controller 120 and high voltage upper phase controller 130 pass through galvanic isolator 150. High voltage upper phase controller 130 may send signals to and receive signals from point-of-use upper phase controller 142 in upper phase power module 140. Point-of-use upper phase controller 142 may send signals to and receive signals from upper phase switches 144. Upper phase switches 144 may be connected to motor 190 and battery 195. Upper phase switches 144 and lower phase switches 148 may be used to transfer energy from motor 190 to battery 195, from battery 195 to motor 190, from an external source to battery 195, or from battery 195 to an external source, for example. The lower phase system of inverter 110 may be similar to the upper phase system as described above.

FIG. 3 depicts an exemplary system infrastructure for inverter controller 300 of FIG. 2, according to one or more embodiments. Inverter controller 300 may include one or more controllers.

The inverter controller 300 may include a set of instructions that can be executed to cause the inverter controller 300 to perform any one or more of the methods or computer based functions disclosed herein. The inverter controller 300 may operate as a standalone device or may be connected, e.g., using a network, to other computer systems or peripheral devices.

In a networked deployment, the inverter controller 300 may operate in the capacity of a server or as a client in a server-client user network environment, or as a peer computer system in a peer-to-peer (or distributed) network environment. The inverter controller 300 can also be implemented as or incorporated into various devices, such as a personal computer (PC), a tablet PC, a set-top box (STB), a personal digital assistant (PDA), a mobile device, a palmtop computer, a laptop computer, a desktop computer, a communications device, a wireless telephone, a land-line telephone, a control system, a camera, a scanner, a facsimile machine, a printer, a pager, a personal trusted device, a web appliance, a network router, switch or bridge, or any other machine capable of executing a set of instructions (sequential or otherwise) that specify actions to be taken by that machine. In a particular implementation, the inverter controller 300 can be implemented using electronic devices that provide voice, video, or data communication. Further, while the inverter controller 300 is illustrated as a single system, the term "system" shall also be taken to include any collection of systems or sub-systems that individually or jointly execute a set, or multiple sets, of instructions to perform one or more computer functions.

As shown in FIG. 3, the inverter controller 300 may include a processor 302, e.g., a central processing unit (CPU), a graphics processing unit (GPU), or both. The processor 302 may be a component in a variety of systems. For example, the processor 302 may be part of a standard inverter. The processor 302 may be one or more general processors, digital signal processors, application specific integrated circuits, field programmable gate arrays, servers, networks, digital circuits, analog circuits, combinations thereof, or other now known or later developed devices for analyzing and processing data. The processor 302 may implement a software program, such as code generated manually (i.e., programmed).

The inverter controller 300 may include a memory 304 that can communicate via a bus 308. The memory 304 may be a main memory, a static memory, or a dynamic memory. The memory 304 may include, but is not limited to computer readable storage media such as various types of volatile and non-volatile storage media, including but not limited to random access memory, read-only memory, programmable read-only memory, electrically programmable read-only memory, electrically erasable read-only memory, flash memory, magnetic tape or disk, optical media and the like. In one implementation, the memory 304 includes a cache or random-access memory for the processor 302. In alternative implementations, the memory 304 is separate from the processor 302, such as a cache memory of a processor, the system memory, or other memory. The memory 304 may be an external storage device or database for storing data. Examples include a hard drive, compact disc ("CD"), digital video disc ("DVD"), memory card, memory stick, floppy disc, universal serial bus ("USB") memory device, or any other device operative to store data. The memory 304 is operable to store instructions executable by the processor 302. The functions, acts or tasks illustrated in the figures or described herein may be performed by the processor 302 executing the instructions stored in the memory 304. The functions, acts or tasks are independent of the particular type of instructions set, storage media, processor or processing strategy and may be performed by software, hardware, integrated circuits, firmware, micro-code and the like, operating alone or in combination. Likewise, processing strategies may include multiprocessing, multitasking, parallel processing and the like.

As shown, the inverter controller 300 may further include a display 310, such as a liquid crystal display (LCD), an organic light emitting diode (OLED), a flat panel display, a solid-state display, a cathode ray tube (CRT), a projector, a printer or other now known or later developed display device for outputting determined information. The display 310 may act as an interface for the user to see the functioning of the processor 302, or specifically as an interface with the software stored in the memory 304 or in the drive unit 306.

Additionally or alternatively, the inverter controller 300 may include an input device 312 configured to allow a user to interact with any of the components of inverter controller 300. The input device 312 may be a number pad, a keyboard, or a cursor control device, such as a mouse, or a joystick, touch screen display, remote control, or any other device operative to interact with the inverter controller 300.

The inverter controller 300 may also or alternatively include drive unit 306 implemented as a disk or optical drive. The drive unit 306 may include a computer-readable medium 322 in which the instructions 324, e.g. software, can be embedded. Further, the instructions 324 may embody one or more of the methods or logic as described herein. The instructions 324 may reside completely or partially within the memory 304 and/or within the processor 302 during execution by the inverter controller 300. The memory 304 and the processor 302 also may include computer-readable media as discussed above.

In some systems, a computer-readable medium 322 includes instructions 324 or receives and executes instructions 324 responsive to a propagated signal so that a device connected to a network 370 can communicate voice, video, audio, images, or any other data over the network 370. Further, the instructions 324 may be transmitted or received over the network 370 via a communication port or interface 320, and/or using a bus 308. The communication port or interface 320 may be a part of the processor 302 or may be a separate component. The communication port or interface 320 may be created in software or may be a physical connection in hardware. The communication port or interface 320 may be configured to connect with a network 370, external media, the display 310, or any other components in inverter controller 300, or combinations thereof. The connection with the network 370 may be a physical connection, such as a wired Ethernet connection or may be established wirelessly as discussed below. Likewise, the additional connections with other components of the inverter controller 300 may be physical connections or may be established wirelessly. The network 370 may alternatively be directly connected to a bus 308.

While the computer-readable medium 322 is shown to be a single medium, the term "computer-readable medium" may include a single medium or multiple media, such as a centralized or distributed database, and/or associated caches and servers that store one or more sets of instructions. The term "computer-readable medium" may also include any medium that is capable of storing, encoding, or carrying a set of instructions for execution by a processor or that cause a computer system to perform any one or more of the methods or operations disclosed herein. The computer-readable medium 322 may be non-transitory, and may be tangible.

The computer-readable medium 322 can include a solid-state memory such as a memory card or other package that houses one or more non-volatile read-only memories. The computer-readable medium 322 can be a random-access memory or other volatile re-writable memory. Additionally or alternatively, the computer-readable medium 322 can include a magneto-optical or optical medium, such as a disk or tapes or other storage device to capture carrier wave signals such as a signal communicated over a transmission medium. A digital file attachment to an e-mail or other self-contained information archive or set of archives may be considered a distribution medium that is a tangible storage medium. Accordingly, the disclosure is considered to include any one or more of a computer-readable medium or a distribution medium and other equivalents and successor media, in which data or instructions may be stored.

In an alternative implementation, dedicated hardware implementations, such as application specific integrated circuits, programmable logic arrays and other hardware devices, can be constructed to implement one or more of the methods described herein. Applications that may include the apparatus and systems of various implementations can broadly include a variety of electronic and computer systems. One or more implementations described herein may implement functions using two or more specific interconnected hardware modules or devices with related control and data signals that can be communicated between and through the modules, or as portions of an application-specific integrated circuit. Accordingly, the present system encompasses software, firmware, and hardware implementations.

The inverter controller 300 may be connected to a network 370. The network 370 may define one or more networks including wired or wireless networks. The wireless network may be a cellular telephone network, an 802.11, 802.16, 802.20, or WiMAX network. Further, such networks may include a public network, such as the Internet, a private network, such as an intranet, or combinations thereof, and may utilize a variety of networking protocols now available or later developed including, but not limited to TCP/IP based networking protocols. The network 370 may include wide area networks (WAN), such as the Internet, local area networks (LAN), campus area networks, metropolitan area networks, a direct connection such as through a Universal Serial Bus (USB) port, or any other networks that may allow for data communication. The network 370 may be configured to couple one computing device to another computing device to enable communication of data between the devices. The network 370 may generally be enabled to employ any form of machine-readable media for communicating information from one device to another. The network 370 may include communication methods by which information may travel between computing devices. The network 370 may be divided into sub-networks. The sub-networks may allow access to all of the other components connected thereto or the sub-networks may restrict access between the components. The network 370 may be regarded as a public or private network connection and may include, for example, a virtual private network or an encryption or other security mechanism employed over the public Internet, or the like.

In accordance with various implementations of the present disclosure, the methods described herein may be implemented by software programs executable by a computer system. Further, in an exemplary, non-limited implementation, implementations can include distributed processing, component or object distributed processing, and parallel processing. Alternatively, virtual computer system processing can be constructed to implement one or more of the methods or functionality as described herein.

Although the present specification describes components and functions that may be implemented in particular implementations with reference to particular standards and protocols, the disclosure is not limited to such standards and protocols. For example, standards for Internet and other packet switched network transmission (e.g., TCP/IP, UDP/IP, HTML, HTTP) represent examples of the state of the art. Such standards are periodically superseded by faster or more efficient equivalents having essentially the same functions. Accordingly, replacement standards and protocols having the same or similar functions as those disclosed herein are considered equivalents thereof.

It will be understood that the operations of methods discussed are performed in one embodiment by an appropriate processor (or processors) of a processing (i.e., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

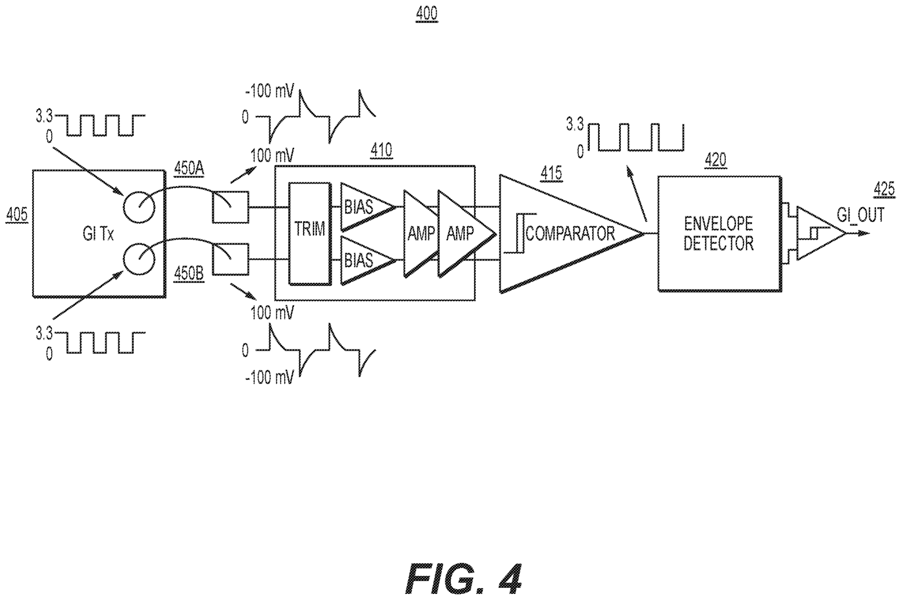

FIG. 4 depicts an exemplary system infrastructure for a galvanic isolation of a low voltage and high voltage controller of FIG. 2, according to one or more embodiments. Galvanic isolator system 400 may include transmitter 405, receiver 410, comparator 415, and envelope detector 420. Transmitter 405 may be connected to receiver 410 via first galvanic connection 450A and second galvanic connection 450B. The duty cycle of pulses seen at the output of comparator 415 may be a function of process and temperature.

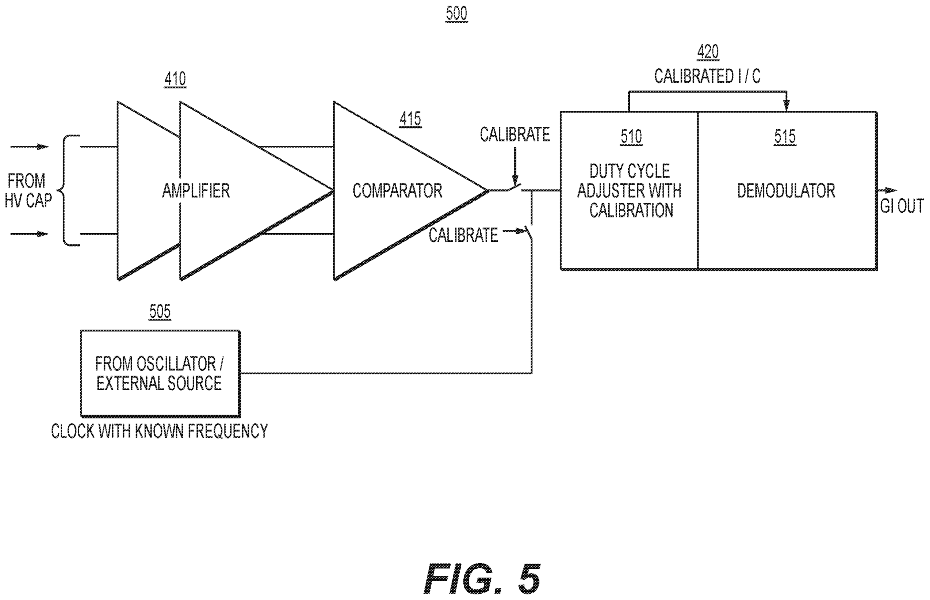

FIG. 5 depicts an exemplary system infrastructure for a duty cycle adjustor and a pulse demodulator for the galvanic isolation receiver, according to one or more embodiments. Envelope detector 420 may be connected to oscillator 505. Galvanic isolator system 500 may include oscillator 505, or oscillator 505 may be external to galvanic isolator system 500. Envelope detector 420 may include duty cycle adjustor 510 and pulse demodulator 515.

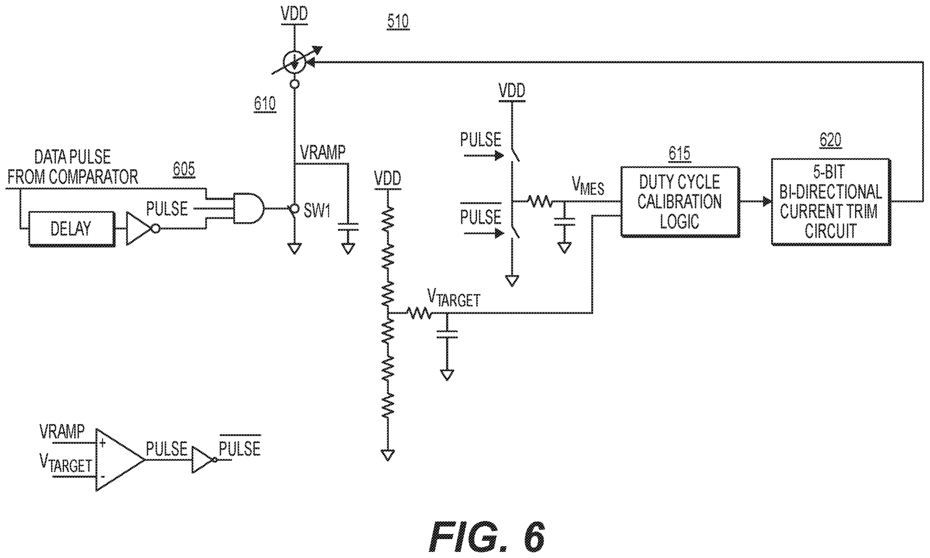

FIG. 6 depicts an exemplary system infrastructure for a duty cycle adjustor, according to one or more embodiments. Duty cycle adjustor 510 may include rising edge detector 605, ramp generator 610, duty cycle trimmer 615, and bidirectional current trimmer 620. Duty cycle adjustor 510 may address a variable duty cycle and ramp rate. Rising edge detector 605 may receive a fixed frequency signal. The incoming pulse may be of any duty cycle, but sufficiently large enough for the rising edge detector 605 to detect a rising edge of the signal. As depicted in FIG. 6, ramp generator 610 may include a current source, a switch, and a capacitor that can vary across processes and temperatures, resulting in a variable ramp rate.

As depicted in FIG. 6, the switch SW1 may be off and the output of the comparator is high, until a pulse appears at the input of rising edge detector 605. The switch SW1 may be controlled by the 'AND" operation of the comparator output 'Pulse' and the output of rising edge detector 605. When the switch of ramp generator 610 sees a rising edge, the switch may turn ON - connecting the capacitor to the ground through the switch. The switch may remain ON as long as the incoming rising edge pulse is high. As depicted in FIG. 6, ramp generator 610 may include an output VRAMP connected to a comparator that generates pulses when VRAMP is below a threshold. This comparator output may be used to gate the signal going into the ramp switch. This may reduce the variability of the rising edge detector 605 to the overall pulse width.

The output of the VRAMP comparator and a complementary signal to the output may be connected to two switches that connect a multi-order low pass filter circuit between supply and ground. The filtered output, VMes, may measure close to half-supply if the duty cycle is 50%. VMes may then be provided to a duty cycle calibration logic, where VMes is compared against a fixed voltage Vtarget (see e.g., FIG. 8). This user-adjustable Vtarget may determine the duty cycle of the generated pulse. Vtarget may be set to half-supply, in response the pulse generated from the comparator output may have approximately 50% duty cycle.

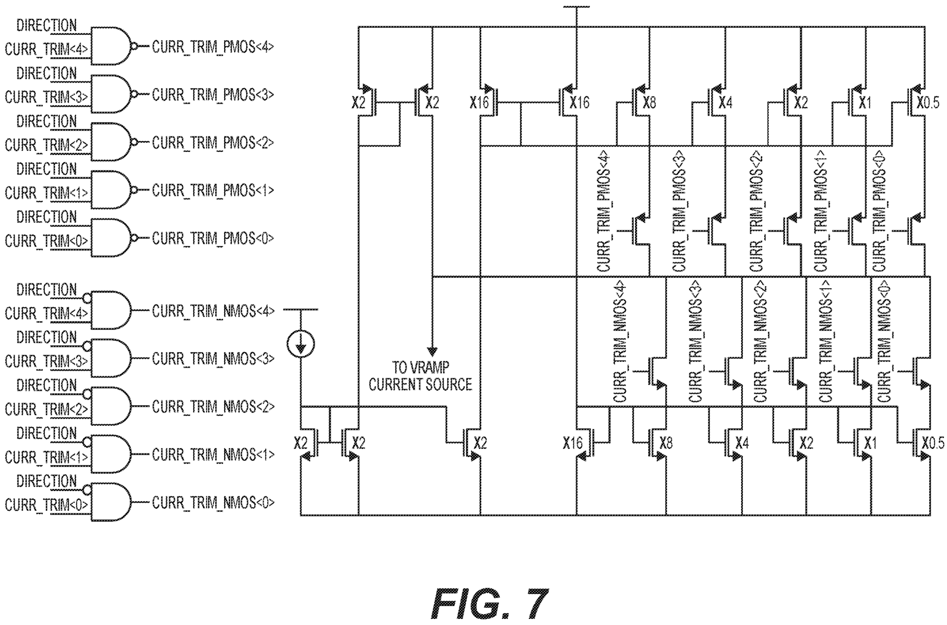

FIG. 7 depicts an exemplary system infrastructure for a bidirectional current trimmer, according to one or more embodiments. Bidirectional current trimmer 620 may include various components as depicted in FIG. 7. The multi-bit (e.g., 5 bit) output of duty cycle trimmer 615 may be sent to a bidirectional current trimmer 620, which may increase or decrease the reference current provided to the ramp generator, which may adjust the ramp rate. This adjusted ramp rate in turn may adjust the duty cycle of the comparator output pulse. The bidirectional trim circuit may be a current mirror circuit that can adjust current up to ±20% from the target value. The adjustment range can be modified based on the number of bits used. The direction bit determines whether additional current needs to be added or subtracted from the original reference current. This bidirectional trim circuit may include 5-bit binary weighted segments. The source and sink functionality depend on the direction bit. When the direction bit is set to one, the current may be added to the original reference current based on the bit weight selection. For example, when the original reference current is 10uA and the maximum range of the trim circuit is 2uA (when all 5 bits are enabled), when direction = 1 and all 5 bits are set (curr_trim<4:0> = 31), the current mirror circuit may generate a total output current of 12uA. When direction = 0 and curr_trim<4:0> = 31, the current mirror circuit may generate a total output current of 8uA.

FIG. 8 depicts an exemplary algorithm for duty cycle calibration, including various operations according to one or more embodiments. Algorithm 800 may begin at START (operation 805). Algorithm 800 may initialize variables VMes, Vtarget, tol_p, and tol_m (operation 810).

VMes may be the voltage at the output (see duty cycle trimmer 615 in FIG. 6) of a multi-order low pass filter connected between the supply and ground through switches, and may be controlled by the output of the VRAMP comparator (see FIG. 6). Target_Vth may be a user-selectable threshold that determines the duty cycle of the pulses coming from the VRAMP comparator. For example, for a 50% duty cycle, Target_Vth may be set to approximately 50% of a supply voltage. For example, for an 80% duty cycle, Target_Vth should be set to approximately 75% of a supply voltage.

Tolerance may be the amount of voltage that may be tolerated as an error. This may account for errors such as the offset present in buffers that drive the VMes, small ripple voltage that is present in VMes, error associated with external measurement devices if any, error in ADC, for example.

Algorithm 800 may initialize increment counter to zero (operation 815). When increment counter is zero, algorithm 800 may determine whether VMes - Vtarget > tol_p (operation 820). When VMes - Vtarget > tol_p (operation 820) and direction is zero (operation 825), increment counter is increased by one (operation 830). When VMes - Vtarget < tol_m (operation 835) and direction is one (operation 840), increment counter is increased by one (operation 845).

When increment counter is not zero, algorithm 800 may determine whether VMes - Vtarget > tol_p, and direction is zero (operation 850). If this condition is true, increment counter is increased by one (operation 855). Algorithm 800 may determine whether VMes - Vtarget < tol_m, and direction is one (operation 860). If this condition is true, increment counter is increased by one (operation 865). Algorithm 800 may determine whether VMes - Vtarget < tol_m, and direction is zero (operation 870). If this condition is true, increment counter is decreased by one (operation 875). Algorithm 800 may determine whether VMes - Vtarget > tol_p, and direction is one (operation 880). If this condition is true, increment counter is decreased by one (operation 885). Algorithm 800 may terminate at STOP (operation 890).

FIG. 9 depicts an exemplary system infrastructure for a duty cycle calibration using a window comparator, according to one or more embodiments. System 900 may include rising edge detector 605, ramp generator 610, bidirectional current trimmer 620, window comparator 930, and duty cycle trimmer 915. Duty cycle trimmer 915 may be implemented as one or more processors, or a digital core, for example. Duty cycle trimmer 915 may include trim logic 920 and counter logic 1100 (see FIG. 11). FIG. 9 may include a system 900 which may include a simplified duty cycle correction circuit using a window comparator.

FIG. 10 depicts an exemplary system infrastructure for a duty cycle calibration using an analog to digital converter, according to one or more embodiments. System 1000 may include rising edge detector 605, ramp generator 610, bidirectional current trimmer 620, and duty cycle trimmer 1015. Duty cycle trimmer 1015 may be implemented as one or more processors, or a digital core, for example. Duty cycle trimmer 1015 may include trim logic 1020, calibration logic 1025, and analog to digital converter 1030. FIG. 10 may include a system 1000 which may include a simplified duty cycle correction circuit using an ADC and a similar logic which may be shown in FIG. 10, and algorithm 800 of FIG. 8 may be used for incrementing or decrementing the ADC code. The duty cycle calibration logic in conjunction with the bidirectional trim circuitry may reduce the effect of variations in ramp current and capacitance across process, corner, and temperature, thus, providing <2% variation in duty cycle and ramp from the target duty cycle / ramp voltage. The accuracy may be further improved by reducing the factors that increase tolerance error such as buffer offset, ripple voltage present in VMes, error associated with external measurement devices if any, error in ADC, etc.

FIG. 11 depicts an exemplary algorithm for a duty cycle calibration counter, according to one or more embodiments. Counter logic 1100 may begin at START (operation 1105). Counter logic 1100 may initialize variables Direction and Trimmed (operation 1110). Counter logic 1100 may determine whether variable Trimmed is equal to one (operation 1115). When Trimmed is equal to one (operation 1115), counter logic 1100 may stop (operation 1140). When Trimmed is not equal to one (operation 1115), counter logic 1100 may determine if variable Increment is equal to zero (operation 1120). When Increment is equal to zero (operation 1120), counter logic 1100 may increase variable Increment by one (operation 1130) and proceed to operation 1110. When Increment is not equal to zero (operation 1120), counter logic 1100 may determine whether variable Direction is equal to variable Previous Direction (operation 1125). When Direction is equal to variable Previous Direction (operation 1125), counter logic 1100 may proceed to operation 1130. When Direction is not equal to variable Previous Direction (operation 1125), counter logic 1100 may decrease Increment by one (operation 1135) and may stop (operation 1140). FIG. 9 may depict a simplified duty cycle correction circuit using a window comparator, and the corresponding counter logic 1100 may be shown in FIG. 11. FIG. 9 may depict a duty cycle correction architecture using a window comparator. VIL represents the target threshold for achieving a required duty cycle. For example, to achieve a 50% duty cycle, VIL should be set to VDD/2. Vtol is a tolerance voltage assumed above and below the target threshold to account for mismatches in the resistor string generating VDD/2, input offset of the comparators, and noise. The outputs of comparators 1 and 2 are NORed together to determine if VMID is within VIL+Vtol or VIL-Vtol. When VMID > VIL+Vtol, the output of comparator 1 is high, and the NORed output is 0, indicating that VMID is not within the window [VIL+Vtol, VIL-Vtol]. The output of comparator 1 determines the direction bit for the bidirectional trim circuit. The NOR gate output and direction signal are sent to the digital core running the duty cycle calibration algorithm. The calibration logic begins when the NORed output is 0 and stops when the NOR gate output is 1. This output is latched after a user-defined filter time (e.g., 200ns to 2us) to prevent bit reversal once calibration is complete or to prevent noise from toggling the output. When the NOR gate output is 0, the algorithm in the digital core checks for the first iteration of the counter. For the first iteration, the direction value is assigned to the previous_direction bit, and the counter is incremented. Depending on the direction bit, the current is either added or removed from the original reference current, adjusting the current in the bidirectional trim circuit and resulting in a variation in VMID and the duty cycle of the pulse. This loop continues until VMID is within the window [VIL+Vtol, VIL-Vtol]. When VMID is within the window, the output of the NOR gate is set to 1, and the calibration routine stops. When the step change in VMID is too large due to the bidirection trim resolution being too small, causing VMID to go below the lower threshold VIL - Vtol, the algorithm decrements the counter by 1, holds the previous trim direction, and stops the calibration routine to prevent the loop from restarting.

FIG. 12 depicts a zoomed-out exemplary plot for waveforms of input clock, calibrated clock, calibration error, and trim code, according to one or more embodiments. Plot 1200 may include input clock plot 1210, calibrated clock plot 1220, calibration error plot 1230, and trim code plot 1240. Input clock plot 1210 depicts an input clock signal (e.g., clock signal from oscillator 505). Plot 1200 may include signals of including input clock, duty cycle corrected clock, calibration error, and output code from the calibration logic circuit (see e.g., FIG. 12).

FIG. 13 depicts a zoomed-in exemplary plot for waveforms of input clock, calibrated clock, calibration error, and trim code, according to one or more embodiments. Plot 1300 may include input clock plot 1310, calibrated clock plot 1320, calibration error plot 1330, and trim code plot 1340, according to one or more embodiments. Plot 1300 may include signals of input clock, duty cycle corrected clock, calibration error, and output code from the calibration logic circuit (see e.g., FIG. 13). As can be seen in FIG. 13, an incoming pulse which may have a 9ns high time and 31ns low time may be converted to a 50% ± 2% duty cycle clock.

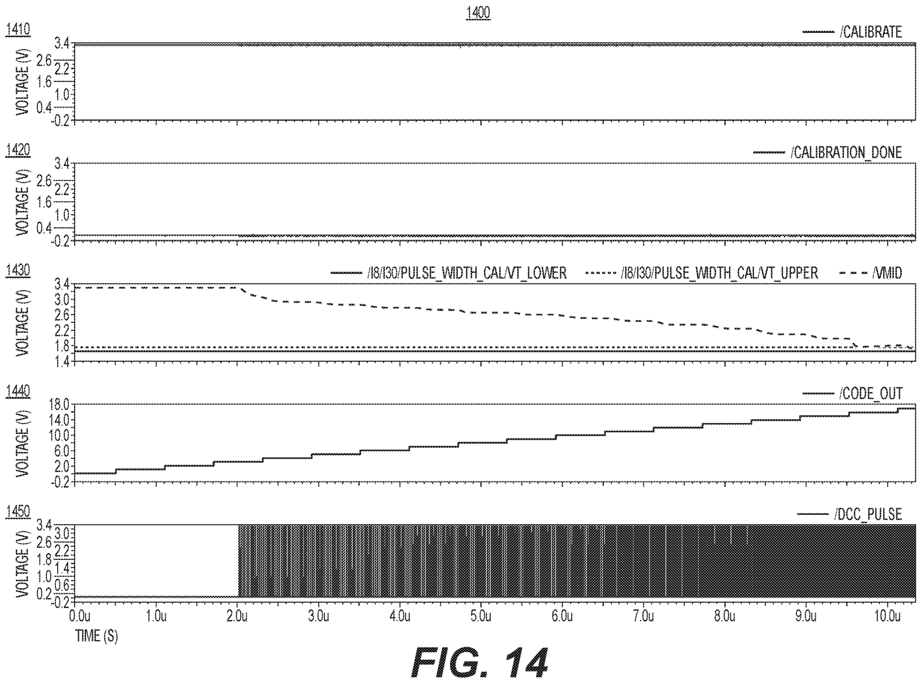

FIG. 14 depicts an exemplary plot for a duty cycle calibration using a window comparator, according to one or more embodiments. Plot 1400 may include calibrate plot 1410, calibration_done plot 1420, VMID plot 1430, codeout plot 1440, and duty cycle plot 1450. FIG. 14 depicts a zoomed out image of the waveforms of calibration logic. Calibrate plot 1410 may be a digital signal that tells the IC that the part (IC) is under calibration routine. Calibration_done plot 1420 may be the NORed comparator outputs of the duty cycle calibration algorithm using window comparator. This signal may be "TRIMMED" in FIG. 9. VMID plot 1430 may be the voltage appearing at the output of RC filter connected to a switch network shown in FIG. 9. Vt_upper and Vt_lower are the upper and lower threshold [VIL+Vtol, VIL-Vtol]. Codeout plot 1440 may be the counter output coming from the digital core as a result of calibration logic. Duty cycle plot 1450 may be the pulse train that turns on and off the switches generating VMID. When Calibration_done signal goes high, the dcc_pulse may have pulses with a required duty cycle.

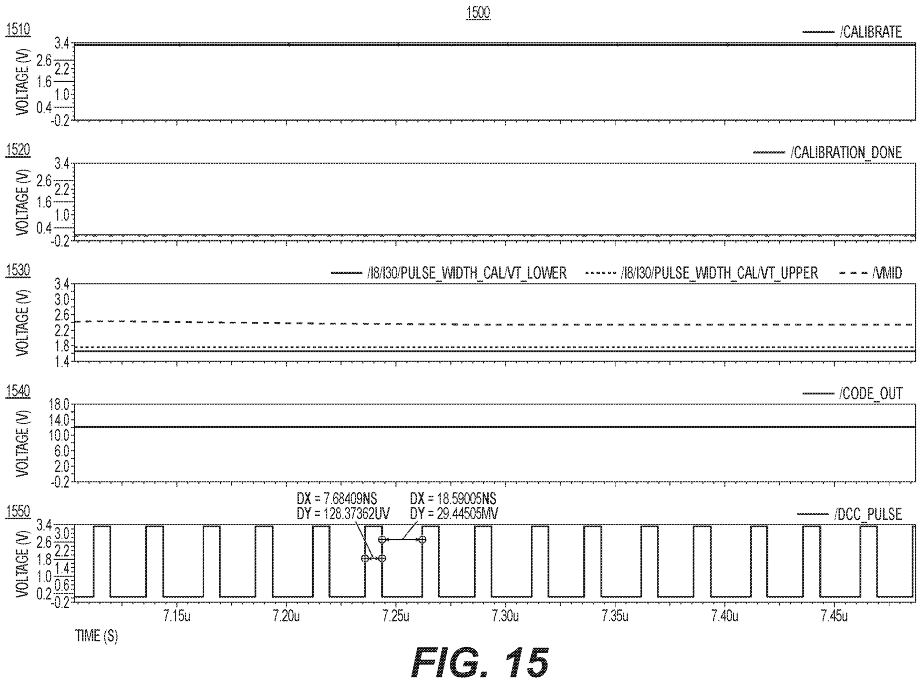

FIG. 15 depicts an exemplary plot for a duty cycle calibration using a window comparator, according to one or more embodiments. Plot 1500 may include calibrate plot 1510, calibration done plot 1520, VMID plot 1530, codeout plot 1540, and duty cycle plot 1550. FIG. 15 depicts a zoomed in image of the waveforms before calibration_done signal is high. As depicted in FIG. 15, VMID is still above vt_upper. The calibration_done signal remains low, preventing the dcc_pulse from reaching a 50% duty cycle.

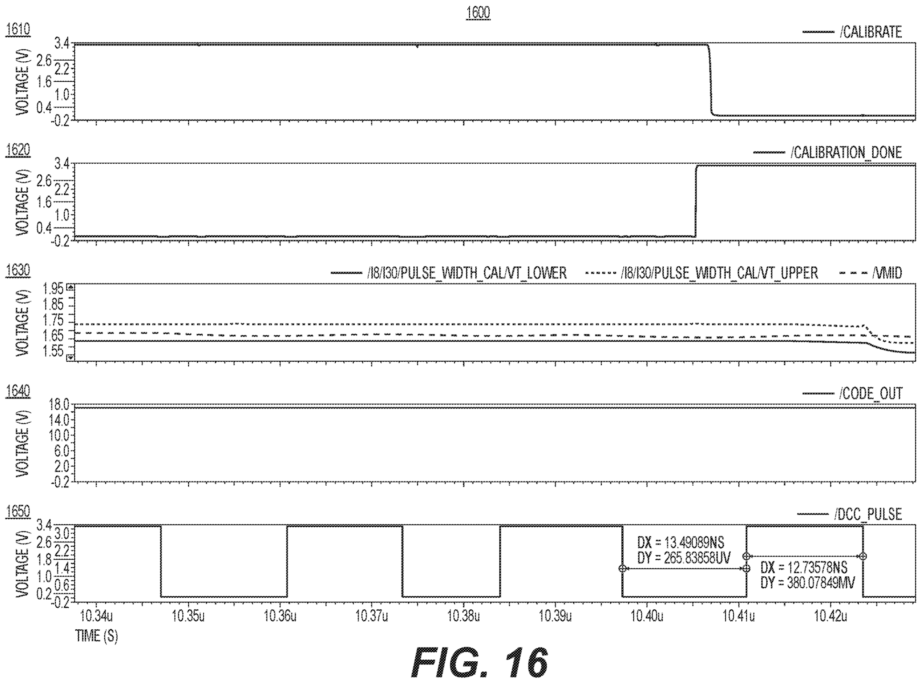

FIG. 16 depicts an exemplary plot for a duty cycle calibration using a window comparator, according to one or more embodiments. Plot 1600 may include calibrate plot 1610, calibration done plot 1620, VMID plot 1630, codeout plot 1640, and duty cycle plot 1650. FIG. 16 depicts a zoomed in image of the waveforms when calibration_done signal goes high. As depicted in FIG. 16, VMID is between vt_upper and vt_lower. This causes the calibration_done signal to go high. Also, the dcc_pulse has reached close to a 50% duty cycle.

FIG. 17A depicts an exemplary system infrastructure for an analog timer for the pulse demodulator of FIG. 5, according to one or more embodiments. FIG. 17B depicts an exemplary stage of the analog timer of FIG. 17A, according to one or more embodiments. Analog timer 1700 may include first stage pulse generator 1710, second stage pulse generator 1740, third stage pulse generator 1755, and fourth stage pulse generator 1770. Although FIG. 17A depicts four stage pulse generators, analog timer 1700 may include less than four stage pulse generators or more than four stage pulse generators. For example, analog timer 1700 may include three stage pulse generators.

In FIG. 17A and FIG. 17B, when the first-stage comparator 1730 detects the first pulse of the incoming pulse train, switch 1720 may turn off, disconnecting the input from the ramp generator. Output signal 1735 of the comparator may stay high until the ramp voltage surpasses the threshold voltage set in the comparator. During this time, the first stage may remain disconnected from the input, so that subsequent pulses are not detected.

Once the output of the first-stage comparator 1730 is high, the second-stage switch may turn on, connecting the input to the second-stage ramp generator. When the second-stage comparator sees the second pulse, the switch may turn off, disconnecting the input from the ramp generator. The output of the second comparator may stay high until the ramp voltage surpasses the threshold voltage set in the comparator. This process may be repeated for the remaining two stages as well. Once the ramp voltage crosses the threshold voltage set in the comparator, the output of the comparator may go low, connecting the ramp generator back to the input through the switch. This process may repeat and may occur for the remaining three stages as well.

First stage pulse generator 1710 may include rising edge detector 1715, switch 1720, rising ramp generator 1725, and first-stage comparator 1730. Second stage pulse generator 1740 may include logic gate 1745 and components similar to first stage pulse generator 1710. Third stage pulse generator 1755 may include logic gate 1760 and components similar to first stage pulse generator 1710. Fourth stage pulse generator 1770 may include logic gate 1775 and components similar to first stage pulse generator 1710.

First stage pulse generator 1710 may receive data pulses 1705 (e.g., from duty cycle adjustor 510). First stage pulse generator 1710 may generate output signal 1735. First stage pulse generator 1710 may operate switch 1720 based on output signal 1735.

Second stage pulse generator 1740 may be connected to first stage pulse generator 1710. Second stage pulse generator 1740 may receive output signal 1735 from first stage pulse generator 1710. Second stage pulse generator 1740 may generate output signal 1750. Second stage pulse generator 1740 may operate a switch based on output signal 1750 and output signal 1735.

Third stage pulse generator 1755 may be connected to second stage pulse generator 1740. Third stage pulse generator 1755 may receive output signal 1750 from second stage pulse generator 1740. Third stage pulse generator 1755 may generate output signal 1765. Third stage pulse generator 1755 may operate a switch based on output signal 1765 and output signal 1750.

Fourth stage pulse generator 1770 may be connected to third stage pulse generator 1755. Fourth stage pulse generator 1770 may receive output signal 1765 from third stage pulse generator 1755. Fourth stage pulse generator 1770 may generate output signal 1780. Fourth stage pulse generator 1770 may operate a switch based on output signal 1780 and output signal 1765.

The first stage pulse generator 1710 of the analog timer 1700 may include a rising edge detector 1715, a rising ramp generator 1725 with a trimmed current, a first-stage comparator 1730, and a switch 1720 that may connect the output of a rising edge detector 1715 to a rising ramp generator 1725. A switch 1720 may be controlled by the output of the first-stage comparator 1730. Specifically, when output signal 1735 is low, switch 1720 may connect the output of the rising edge detector 1715 to the rising ramp generator 1725.

The second stage pulse generator 1740 may resemble the first stage, except that a switch of the second stage pulse generator 1740 may be controlled by both output signal 1750 and output signal 1735.

The number of stages required for demodulation may depend on the maximum number of pulses that can be lost due to noise while still providing a robust non-glitch output. For example, assuming only one pulse can be lost due to noise, a minimum of three stages may be necessary. However, for enhanced system robustness, a fourth stage may be added.

When the first-stage comparator 1730 detects the first pulse of the incoming pulse train, the switch 1720 may turn off, disconnecting the input from the rising ramp generator 1725. The output of the first-stage comparator 1730 may stay high until the ramp voltage surpasses the threshold voltage set in the first-stage comparator 1730. During this time, the first stage pulse generator 1710 may remain disconnected from the data pulses 1705, so the rising ramp generator 1725 cannot detect the subsequent pulses.

Once the output signal 1735 of the first-stage comparator 1730 is high, the second-stage switch may turn on, connecting the data pulses 1705 to the second-stage ramp generator. When the second-stage comparator sees the second pulse, the switch may turn off, disconnecting the input from the ramp generator. The output signal 1750 of the second comparator may stay high until the ramp voltage surpasses the threshold voltage set in the comparator. This process may be repeated for the remaining two stages as well. Once the ramp voltage crosses the threshold voltage set in the comparator, the output signal 1750 of the comparator may go low, connecting the ramp generator back to the data pulses 1705 through the switch. This process may repeat and may occur for the remaining three stages as well. By default, the output signal 1735 of the first-stage comparator 1730 is low and first switch is connected to first rising edge detector until it sees a pulse at its input. When the first stage sees a pulse, the output of the first stage comparator goes high and remains high for a period of 4 clocks ( = number of stages). The stage 2 comparator output is low and the switch remains disconnected until output of comparator in stage 1 goes high. When the output of comparator in stage 1 goes high, the switch in stage 2 connects the rising edge detector output to second stage ramp generator input. The switch in second stage remains connected until the second stage rising edge detector detects a pulse. When the second stage rising edge detector detects a pulse at its input, the switch is disconnected and a ramp is generated in second stage. During this period, the output of comparator in stage 2 is high. This process continues for subsequent stages and repeats until the rising edge detectors doesn't see any incoming pulses at its input or see pulses after periods equivalent to >2 pulses apart.

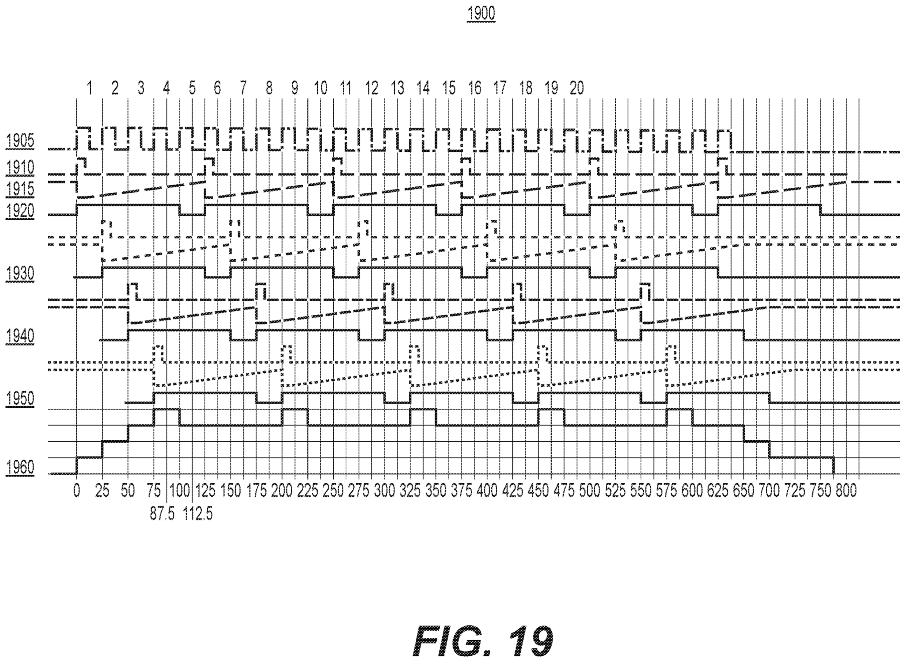

FIG. 18 depicts an exemplary system infrastructure for a voltage translator for the pulse demodulator of FIG. 5, according to one or more embodiments. Voltage translator 1800 may include voltage divider 1815 and comparator 1805. Comparator 1805 may generate output signal 1810. Voltage divider 1815 may include first resistor tap point 1835, second resistor tap point 1850, third resistor tap point 1865, and fourth resistor tap point 1880. First resistor tap point 1835 may receive output signal 1735 from first stage pulse generator 1710 through a first resistor string, as depicted in FIG. 18. Second resistor tap point 1850 may receive output signal 1750 through a second resistor string, as depicted in FIG. 18. Third resistor tap point 1865 may receive output signal 1765 through a third resistor string, as depicted in FIG. 18. Fourth resistor tap point 1880 may receive output signal 1780 through a fourth resistor string, as depicted in FIG. 18. FIG. 18 depicts an output of the comparators that is scaled and summed using the resistor network from first resistor tap point 1835 to fourth resistor tap point 1880. The output waveform of first resistor tap point 1835, second resistor tap point 1850, third resistor tap point 1865, and fourth resistor tap point 1880 has a shape represented by demodulator output 1960 in FIG. 19. The output of the resistor network is then fed to the positive terminal of a comparator, with a negative terminal that is connected to different tap points in a resistor string. Depending on the output of the comparator, the tap points are switched to provide hysteresis. When the output of the resistor network waveform crosses the upper threshold seen at the negative terminal of the comparator, the output of the comparator goes high and connects the negative terminal to the lowest tap point in the resistor string. The output of the comparator GI_OUT remains high until the resistor network waveform goes below the lower new threshold level seen at the negative terminal of the comparator.

Although FIG. 18 depicts four resistor strings, voltage divider 1815 may include less than four resistor strings or more than four resistor strings. For example, voltage divider may include three resistor strings. Although FIG. 18 depicts four resistor tap points, voltage divider may include less than four resistor tap points or more than four resistor tap points. For example, voltage divider may include three resistor tap points. Output signal 1735, output signal 1750, output signal 1765 and output signal 1780 may be connected as shown in FIG. 18. Depending on the desired input range of the level translator detection comparator, suitable tap points from the resistor strings may be shorted. When the shorted voltage goes above the set threshold voltage, the comparator output (e.g., comparator 1805 output GI_OUT) may go high. The threshold voltage may then be set to a lower level using the switch connected to the resistor tap point and the output of the comparator. The output of the comparator may remain high until the level translator voltage goes below the lower threshold voltage.

FIG. 19 depicts an exemplary plot for demodulator waveforms in an ideal ramp rate, according to one or more embodiments. Plot 1900 includes data pulses 1905, rising edge detector output 1910, rising ramp generator output 1915, first stage pulse generator output 1920, second stage pulse generator output 1930, third stage pulse generator output 1940, fourth stage pulse generator output 1950, and demodulator output 1960.

Data pulses 1905 may correlate with data pulses 1705, for example. Rising edge detector output 1910 may correlate with an output of rising edge detector 1715, for example. Rising ramp generator output 1915 may correlate with an output of rising ramp generator 1725, for example. First stage pulse generator output 1920 may correlate with output signal 1735, for example. Second stage pulse generator output 1930 may correlate with output signal 1750, for example. Third stage pulse generator output 1940 may correlate with output signal 1765, for example. Fourth stage pulse generator output 1950 may correlate with output signal 1780, for example. Demodulator output 1960 may correlate with an output signal of pulse demodulator 515, for example.

As depicted in FIG. 19, rising edge detector output 1910 may be based on a rising edge of data pulses 1905. Rising ramp generator output 1915 may be a ramp signal that increases from a first pulse of rising edge detector output 1910 to a second pulse of rising edge detector output 1910. First stage pulse generator output 1920 may be based on a comparison of a value of rising ramp generator output 1915 to a threshold value. As depicted in FIG. 19, second stage pulse generator output 1930, third stage pulse generator output 1940, and fourth stage pulse generator output 1950 are based on rising edge detector outputs and rising ramp generator outputs that may be similar to rising edge detector output 1910 and rising ramp generator output 1915 for first stage pulse generator output 1920, and are not labeled in FIG. 19. Demodulator output 1960 may be a summation of first stage pulse generator output 1920, second stage pulse generator output 1930, third stage pulse generator output 1940, and fourth stage pulse generator output 1950.

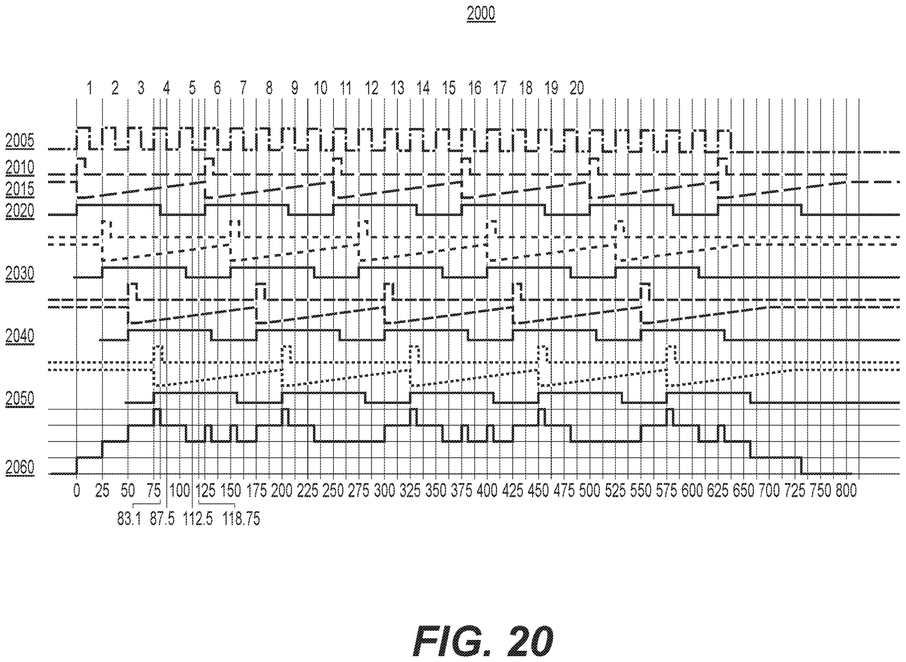

FIG. 20 depicts an exemplary plot for demodulator waveforms with a faster ramp rate, according to one or more embodiments. Plot 2000 includes data pulses 2005, rising edge detector output 2010, rising ramp generator output 2015, first stage pulse generator output 2020, second stage pulse generator output 2030, third stage pulse generator output 2040, fourth stage pulse generator output 2050, and demodulator output 2060. Signals in plot 2000 may be similar to signals in plot 1900, except that the ramp rate in plot 2000 may be faster than the ramp rate in plot 1900. It is almost impossible to achieve 100% accuracy in duty cycle pulses and their corresponding ramp signal using some methods. The ramp rates and thus the current may vary slightly across different temperatures and conditions such as process and voltage. Although the duty cycle calibration procedure has reduced the variation due to process, voltage, and temperature (PVT), the duty cycle calibration procedure may not completely eliminate the variation due to limited trim bits and wide tolerance levels. These limitations will cause variations in the currents needed to generate the ramps for producing the desired duty cycle pulses. Additionally, the current from the duty cycle calibration circuit has been mirrored and scaled down by a factor of 4 (or any desired factor), which further introduces errors leading to different ramp rates. In plot 2000, the worst-case condition occurs when the mirrored current is larger than the expected nominal value, resulting in faster ramp rates. This leads to steeper ramps and slightly narrower pulses at the output signals 1735, 1750, 1765, and 1780, as shown in first stage pulse generator output 2020, second stage pulse generator output 2030, third stage pulse generator output 2040, and fourth stage pulse generator output 2050.

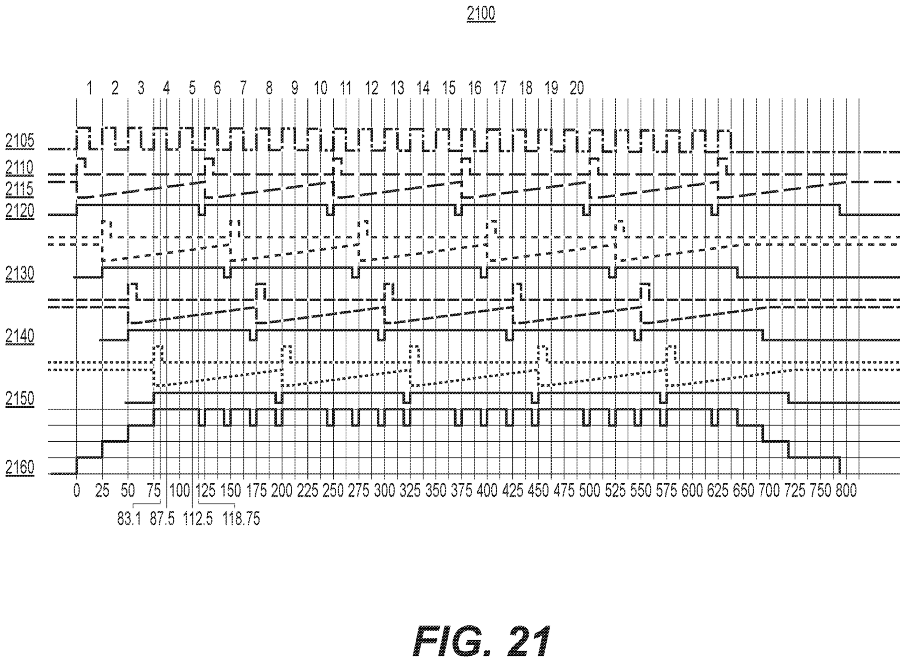

FIG. 21 depicts an exemplary plot for demodulator waveforms with a slower ramp rate, according to one or more embodiments. Plot 2100 includes data pulses 2105, rising edge detector output 2110, rising ramp generator output 2115, first stage pulse generator output 2120, second stage pulse generator output 2130, third stage pulse generator output 2140, fourth stage pulse generator output 2150, and demodulator output 2160. Signals in plot 2100 may be similar to signals in plot 1900, except that the ramp rate in plot 2100 may be faster than the ramp rate in plot 1900. In plot 2100, the mirrored current is smaller than the expected nominal current, resulting in slower ramp rates. This leads to wider pulses at the output of comparators, as shown in first stage pulse generator output 2120, second stage pulse generator output 2130, third stage pulse generator output 2140, and fourth stage pulse generator output 2150.

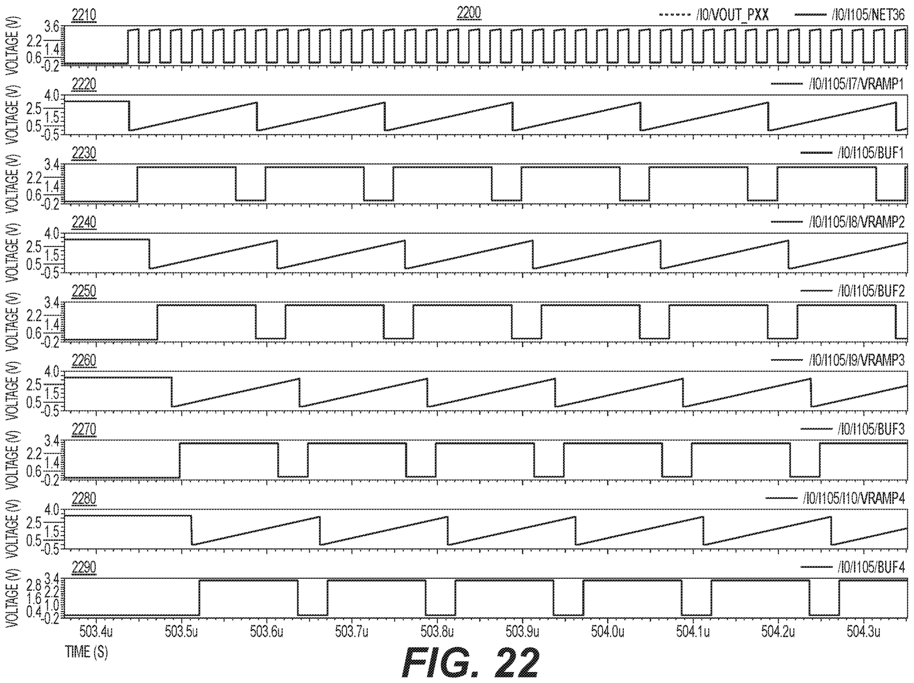

FIG. 22 depicts an exemplary plot for demodulator waveforms from various stages, according to one or more embodiments. Plot 2200 includes data pulses 2210, first rising ramp generator output 2220, first stage pulse generator output 2230, second rising ramp generator output 2240, second stage pulse generator output 2250, third rising ramp generator output 2260, third stage pulse generator output 2270, fourth rising ramp generator output 2280, and fourth stage pulse generator output 2290.

Data pulses 2210 may correlate with data pulses 1705, for example. First rising ramp generator output 2220 may correlate with an output of rising ramp generator 1725, for example. First stage pulse generator output 2230 may correlate with output signal 1735, for example. Second rising ramp generator output 2240 may correlate with an output of the rising ramp generator of second stage pulse generator 1740, for example. Second stage pulse generator output 2250 may correlate with output signal 1750, for example. Third rising ramp generator output 2260 may correlate with an output of the rising ramp generator of third stage pulse generator 1755, for example. Third stage pulse generator output 2270 may correlate with output signal 1765, for example. Fourth rising ramp generator output 2280 may correlate with an output of the rising ramp generator of fourth stage pulse generator 1770, for example. Fourth stage pulse generator output 2290 may correlate with output signal 1780, for example.

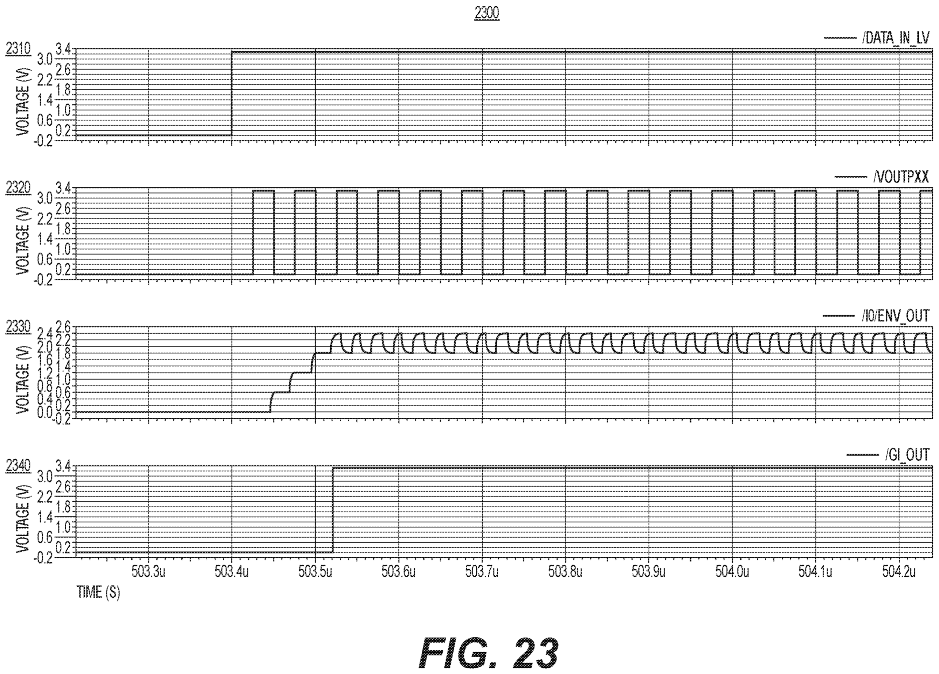

FIG. 23 depicts an exemplary plot for rising edges of averaged comparator outputs, according to one or more embodiments. Plot 2300 includes data input 2310, duty cycle output 2320, demodulator output 2330, and data output 2340. Data input 2310 may be a rising edge portion of signal from transmitter 405, for example. Duty cycle output 2320 may be a signal from duty cycle adjustor 510, for example. Demodulator output 2330 may be a signal from pulse demodulator 515, for example. Data output 2340 may correlate with signal output 425, for example.

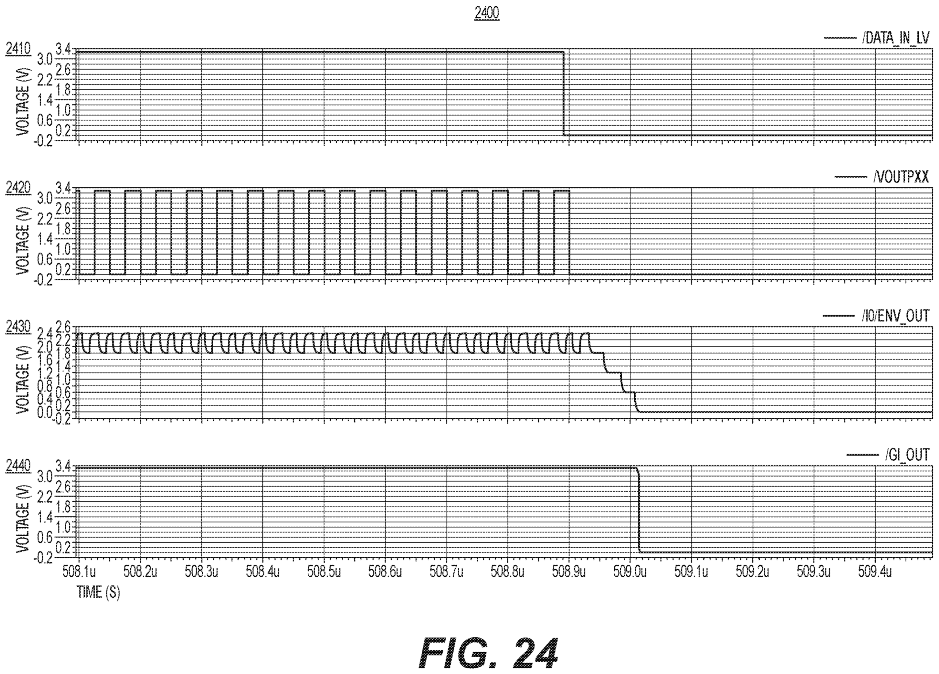

FIG. 24 depicts an exemplary plot for falling edges of averaged comparator outputs, according to one or more embodiments. Plot 2400 includes data input 2410, duty cycle output 2420, demodulator output 2430, and data output 2440. Data input 2410 may be a falling edge portion of signal from transmitter 405, for example. Duty cycle output 2420 may be a signal from duty cycle adjustor 510, for example. Demodulator output 2430 may be a signal from pulse demodulator 515, for example. Data output 2440 may correlate with signal output 425, for example.

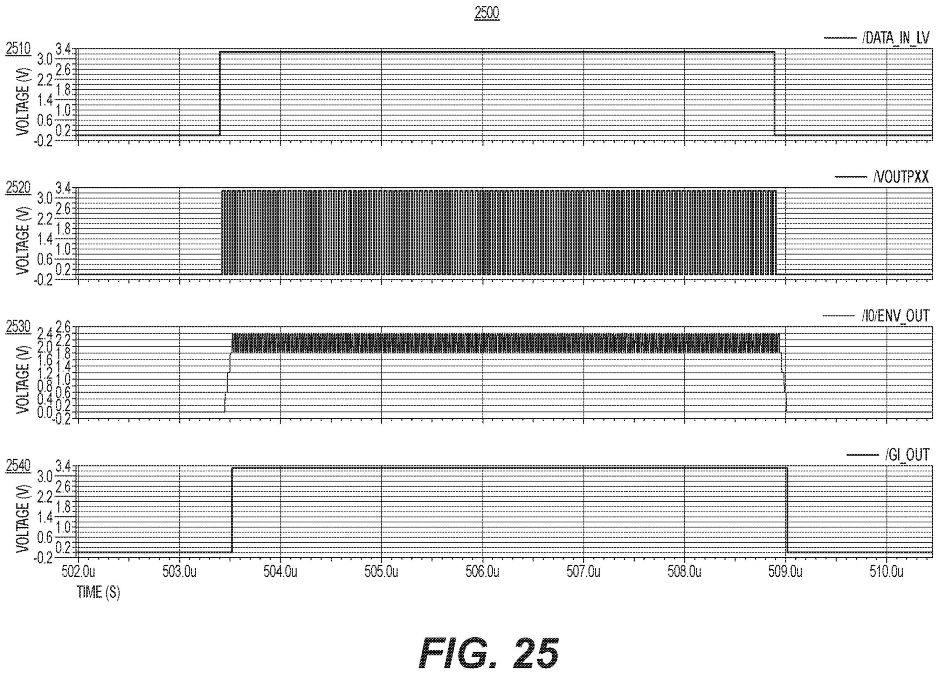

FIG. 25 depicts an exemplary plot for demodulated signals, according to one or more embodiments. Plot 2500 includes data input 2510, duty cycle output 2520, demodulator output 2530, and data output 2540. Data input 2510 may be a signal from transmitter 405, for example. Duty cycle output 2520 may be a signal from duty cycle adjustor 510, for example. Demodulator output 2530 may be a signal from pulse demodulator 515, for example. Data output 2540 may correlate with signal output 425, for example. FIG. 25 may be an entirety of a pulse depicted with a rising edge in FIG. 23 and a falling edge in FIG. 24.

The duty cycle calibration logic in conjunction with the bidirectional trim circuitry may reduce the effect of variations in ramp current and capacitance across process, corner, and temperature, thus, providing <2% variation in duty cycle and ramp from the target duty cycle / ramp voltage. The accuracy may be further improved by reducing the factors that increase tolerance error such as buffer offset, ripple voltage present in VMes, error associated with external measurement devices if any, error in ADC, etc.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising an inverter configured to convert DC power from a battery to AC power, wherein the inverter includes:
a pulse demodulator including:
an analog timer including:
a first stage pulse generator,
a second stage pulse generator connected to the first stage pulse generator, and
a third stage pulse generator connected to the second stage pulse generator; and
a voltage translator including:
a voltage divider connected to the first stage pulse generator, the second stage pulse generator, and the third stage pulse generator, and
a comparator connected to the voltage divider.

2. The system of claim 1, wherein the first stage pulse generator includes:
a first rising edge detector;
a first ramp generator with a first trimmed current;
a first comparator; and
a first switch;
wherein the first switch connects an output of the first rising edge detector to the first ramp generator, and
wherein the first switch is operated based on an output of the first comparator.

3. The system of claim 2, wherein the second stage pulse generator includes:
a second rising edge detector;
a second ramp generator with a second trimmed current;
a second comparator; and
a second switch,
wherein the second switch connects the output of the second rising edge detector to the second ramp generator, and
wherein the second switch is operated based on the output of the second comparator and the output of the first comparator.

4. The system of claim 3, wherein the second stage pulse generator further includes a logic gate including:
a first input connected to the output of the first comparator,
a second input connected to the output of the second comparator, and
an output configured to control an operation of the second switch;
and preferably wherein the logic gate is configured to control the second switch to open, to disconnect an output of the second rising edge detector from an input of the second ramp generator, when the output of the first comparator is OFF and the output of the second comparator is ON.

5. The system of claim 3, wherein the third stage pulse generator includes:
a third rising edge detector;
a third ramp generator with a third trimmed current;
a third comparator; and
a third switch,
wherein the third switch connects the output of the third rising edge detector to the third ramp generator, and
wherein the third switch is operated based on the output of the third comparator and the output of the second comparator.

6. The system of claim 5, wherein:
the analog timer further includes a fourth stage pulse generator connected to the third stage pulse generator; and
the voltage divider is further connected to the fourth stage pulse generator.

7. The system of claim 6, wherein the fourth stage pulse generator includes:
a fourth rising edge detector;
a fourth ramp generator with a fourth trimmed current;
a fourth comparator; and
a fourth switch,
wherein the fourth switch connects the output of the fourth rising edge detector to the fourth ramp generator, and
wherein the fourth switch is operated based on the output of the fourth comparator and the output of the third comparator;
and/or wherein the voltage divider includes:
a first resistor string connected to the first stage pulse generator,
a first resistor tap point from the first resistor string,
a second resistor string connected to the second stage pulse generator,
a second resistor tap point from the second resistor string,
a third resistor string connected to the third stage pulse generator,
a third resistor tap point from the third resistor string,
a fourth resistor string connected to the fourth stage pulse generator, and
a fourth resistor tap point from the fourth resistor string.

8. The system of any one of claims 1 to 7, wherein the inverter further includes: a duty cycle adjustor connected to the pulse demodulator.

9. The system of any one of claims 1 to 8, wherein the voltage divider includes:
a first resistor string connected to the first stage pulse generator,
a first resistor tap point from the first resistor string,
a second resistor string connected to the second stage pulse generator,
a second resistor tap point from the second resistor string,
a third resistor string connected to the third stage pulse generator, and
a third resistor tap point from the third resistor string.

10. The system of any one of claims 1 to 9, wherein the comparator of the voltage translator is configured to output a signal based on a threshold voltage and one or more output signals of the analog timer.

11. The system of any one of claims 1 to 10, further comprising:
the battery configured to supply the DC power to the inverter; and
a motor configured to receive the AC power from the inverter to drive the motor,
wherein the inverter, the battery, and the motor are provided as a vehicle.

12. A system comprising a pulse demodulator, wherein the pulse demodulator includes:
an analog timer including:
a first stage pulse generator,
a second stage pulse generator connected to the first stage pulse generator, and
a third stage pulse generator connected to the second stage pulse generator; and
a voltage translator including:
a voltage divider connected to the first stage pulse generator, the second stage pulse generator, and the third stage pulse generator, and
a comparator connected to the voltage divider.
and wherein the voltage translator is preferably configured to output a signal based on a summation of an output of the first stage pulse generator, an output of the second stage pulse generator, and an output of the third stage pulse generator.

13. A method comprising:
receiving an input pulse;
generating a first rising edge pulse based on the input pulse;
generating a first ramp signal based on the first rising edge pulse;
generating a first comparator signal based on the first ramp signal;
generating a second rising edge pulse based on the input pulse and the first ramp signal;
generating a second ramp signal based on the second rising edge pulse;
generating a second comparator signal based on the second ramp signal; and
generating a summation signal of the first comparator signal and the second comparator signal.

14. The method of claim 13, wherein the generating the first rising edge pulse includes:
comparing a first pulse of the input pulse with a threshold voltage of a first comparator; and
closing a switch allowing a rising ramp generator to receive the first rising edge pulse based on an output of the first comparator when the voltage surpasses the threshold voltage set by the first comparator;
and/or wherein generating the first ramp signal includes:
receiving the first rising edge pulse and generating a rising ramp signal based on the first rising edge pulse.

15. The method of claim 13 or 14, wherein generating the first comparator signal includes:
comparing the first ramp signal with a threshold voltage,
wherein an output of the first comparator remains high until the ramp voltage surpasses the threshold voltage, and
wherein when the ramp voltage surpasses the threshold voltage the output goes low and a switch opens;
and/or wherein generating the second rising edge pulse includes:
comparing a received pulse and the first ramp signal; and
detecting the received pulse and turning off a switch thereby disconnecting the input from the ramp generator,
wherein an output of the second comparator remains high until a voltage of the second ramp signal surpasses a threshold voltage set in the comparator.
